(19)

Europäisches
Patentamt
European
Patent Office
Office européen
des brevets

(11) **EP 3 121 709 A1**

(12) **EUROPEAN PATENT APPLICATION**

(43) Date of publication:
**25.01.2017 Bulletin 2017/04**

(21) Application number: **15178389.1**

(22) Date of filing: **24.07.2015**

(51) Int Cl.:
*G06F 7/544* $^{(2006.01)}$     *G01Q 10/06* $^{(2010.01)}$
*B82Y 35/00* $^{(2011.01)}$

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(71) Applicant: **Universität Basel**
**4003 Basel (CH)**

(72) Inventors:
• **BUBENDORF, Alexander**
**F-68480 Sondersdorf (FR)**
• **MEYER, Ernst**
**CH-4132 Muttenz (CH)**
• **GLATZEL, Thilo**
**D-79594 Inzlingen (DE)**

(74) Representative: **Schulz Junghans**
**Patentanwälte PartGmbB**
**Großbeerenstraße 71**
**10963 Berlin (DE)**

(54) **ALGORITHM FOR PHASE COMPUTATION IN LOCK-IN TECHNIQUE**

(57) The invention relates to a method for estimating a phase shift between an in-phase component and a quadrature component provided by a lock-in amplifier, comprising the steps of: Providing an input signal (U), Providing a first reference signal ($V_{ref}$), Providing a second reference signal ($V_{ref,}+_{90° \text{ phase shifted}}$) that is phase shifted by +90° with respect to the first reference signal ($V_{ref}$), Calculating said in-phase component (X) with the lock-in amplifier, which calculation comprises at least multiplying said first reference signal with the input signal and low-pass filtering the result to yield said in-phase component (x), Calculating said quadrature component (Y) with the lock-in amplifier, which calculation comprises at least multiplying said second reference signal with the input signal and low-pass filtering the result to yield said quadrature component (Y), and Estimating the phase (Z) using the in-phase component and the quadrature component by means of a CORDIC algorithm.

Fig. 1

EP 3 121 709 A1

**EP 3 121 709 A1**

**Description**

Lock-in technology and phase-locked loop techniques are essential for instrumentation, where small oscillating signals are to be measured. Especially, the field of atomic force microscopy is based on the measurements of small oscillations of the cantilever-type springs. The main purpose is to control the cantilever oscillation and to measure the physical parameters of frequency shift, amplitude, excitation signal and phase shifts. Field programmable gate arrays (FPGA) are fast enough to measure and control oscillations in the frequency range from mHz to several MHz. In order to control the oscillation it is necessary to measure the phase between the excitation signal and the response signal. It is found that previous realizations use approximations, which lead to rather large errors in the phase measurement and can also lead to instabilities of the oscillations.

Therefore, the problem underlying the present invention is to provide a method that allows to calculate a phase with high accuracy and to avoid said instabilities.

This problem is solved by a method having the features of claim 1. Preferred embodiments are stated in the sub claims and are described below.

According to claim 1, the method according to the invention for estimating a phase shift between an in-phase component and a quadrature component provided by a lock-in amplifier comprises the steps of

- Providing an input signal $U$ that is preferably sinusoidal,
- Providing a first reference signal $V_{ref} = A \cdot \sin(2 \cdot \pi \cdot f \cdot t + \emptyset_0)$, wherein particularly $f$ is the frequency of the signal, $A$ is the amplitude of the signal, and $\emptyset_0$ is the phase at the origin,
- Providing a second reference signal $V_{ref,+90° \text{ phase shifted}} = A \cdot \cos(2 \cdot \pi \cdot f \cdot t + \emptyset_0)$ that is preferably +90° phase shifted with respect to the first reference signal $V_{ref}$,
- Calculating said in-phase component (X) with the lock-in amplifier, which calculation comprises at least multiplying said first reference signal with the input signal and low-pass filtering the result to yield said in-phase component (x),
- Calculating said quadrature component ($Y$) with the lock-in amplifier, which calculation comprises at least multiplying said second reference signal with the input signal and low-pass filtering the result to yield said quadrature component (Y),
- Estimating the phase (Z) using the in-phase component and the quadrature component by means of a CORDIC algorithm.

This algorithm is also known as Volder's algorithm (see also Reference [1] which is incorporated herein by reference in its entirety). The CORDIC algorithm is an algorithm that is adapted to iteratively rotate a vector by a plurality of n discrete angles wherein performing the $(i + 1)$th rotation by the $i$th angle ($\alpha_i$) comprises obtaining the x-component $x_{i+1}$ of the vector in the $(i + 1)$th iteration step by adding the y-component $y_i$ of the vector multiplied by a value depending on $i$ to the x-component $x_i$ of the vector, and obtaining the y-component $y_{i+1}$ of the vector in the $(i + 1)$th iteration step by adding the x-component $x_i$ of the vector multiplied by a value depending on i to the y-component $y_i$ of the vector. Particularly, this is also denoted as "cross-addition". In this regard, the CORDIC algorithm is a shift-add algorithm.

This shift-add algorithm can be achieved by first considering the Givens rotation transform that rotates a 2D vector ($x$, $y$) in a Cartesian plane by the angle $\phi$:

$$x' = x \cos \phi - y \sin \phi$$

$$y' = y \cos \phi + x \sin \phi,$$

or, in a rearranged form:

$$x' = \cos \phi \, [x - y \tan \phi],$$

$$y' = \cos \phi \, [y + x \tan \phi].$$

Limiting the rotation angles such that $_{\tan}\phi = \pm 2^{-i}$ this transform can be written in the form of an iteration using merely a simple shift operation:

$$x_{i+1} = K_i[x_i - y_i d_i 2^{-i}],$$

$$y_{i+1} = K_i[y_i + x_i d_i 2^{-i}],$$

wherein $K_i = \cos\left(\tan^{-1} 2^{-i}\right) = \dfrac{1}{\sqrt{1 + 2^{-2i}}}$, and $d_i = \pm 1$.

The scale constant $K_i$ can further be removed from these equations. Instead a corresponding gain $A_n$ is multiplied to the iteration outcome, wherein $A_n = \prod_n \sqrt{1 + 2^{-2i}}$, see also below [2].

The invention can compute precisely all the phase values in the $[\pm\pi[$ rad or $[\pm 180[$ deg domain from the in-phase and quadrature components X and Y computed with said lock-in amplifier.

Preferably, according to an embodiment of the method according to the invention, the phase computation is done by determining arctan(Y/X) by the mean of the CORDIC algorithm (see also [1]).

The three equations of the CORDIC algorithm for the computation of the atan function are

$$x_{i+1} = x_i + \text{sign}(x_i) \cdot \text{sign}(y_i) \cdot y_i \cdot 2^{-i}$$

$$y_{i+1} = y_i - \text{sign}(x_i) \cdot \text{sign}(y_i) \cdot x_i \cdot 2^{-i}$$

with $i \in \{0, \dots, n - 1\}$

$$z_{i+1} = z_i + \text{sign}(x_i) \cdot \text{sign}(y_i) \cdot \tan^{-1}(2^{-i})$$

wherein $x_0 = X$, $y_0 = Y$, $z_0 = 0$, and wherein
the estimator of the phase Z is

$$z_n = z_0 + \tan^{-1}\left(\frac{y_0}{x_0}\right),$$

and one further has

$$y_n = 0,$$

and

$$x_n = A_n\sqrt{{x_0}^2 + {y_0}^2}.$$

This mode of the CORDIC algorithm is also denoted as vectoring mode. In this mode, the CORDIC algorithm rotates the input vector until the result vector is aligned with the x axis. The result of the vectoring mode is a rotation angle and the scaled magnitude of the original vector.

Alternatively, the phase can also be computed from the asin(Y/R) and acos(X/R) by the mean of the CORDIC algorithm where $R = \sqrt{X^2 + Y^2}$ is the hypotenuse of the right triangle of sides X and Y and computed with the Euclidian norm. However, the standard equations of the CORDIC algorithm for the computation of asin(Y/R) and acos(X/R) have to be modified by using a double iteration algorithm to correct the gain.

The computation of the phase with the asin and acos by the mean of the CORDIC algorithm makes it even more so unsuited that one needs to compute first R before the phase contrary to the atan where the phase and R can be computed in parallel. The three standard equations for the computation of the asin function are

$$x_{i+1} = x_i - \varepsilon_i \cdot y_i \cdot 2^{-i}$$

$$y_{i+1} = y_i + \varepsilon_i \cdot x_i \cdot 2^{-i}$$

with $i \in \{0, \dots, n-1\}$

$$z_{i+1} = z_i - \varepsilon_i \cdot \tan^{-1}(2^{-i}),$$

wherein $x_0 = \textit{unit vector}$, $y_0 = Y$, $z_0 = 0$
$\varepsilon_i$ =+1 if $y_i$ <Y/R, -1 else.

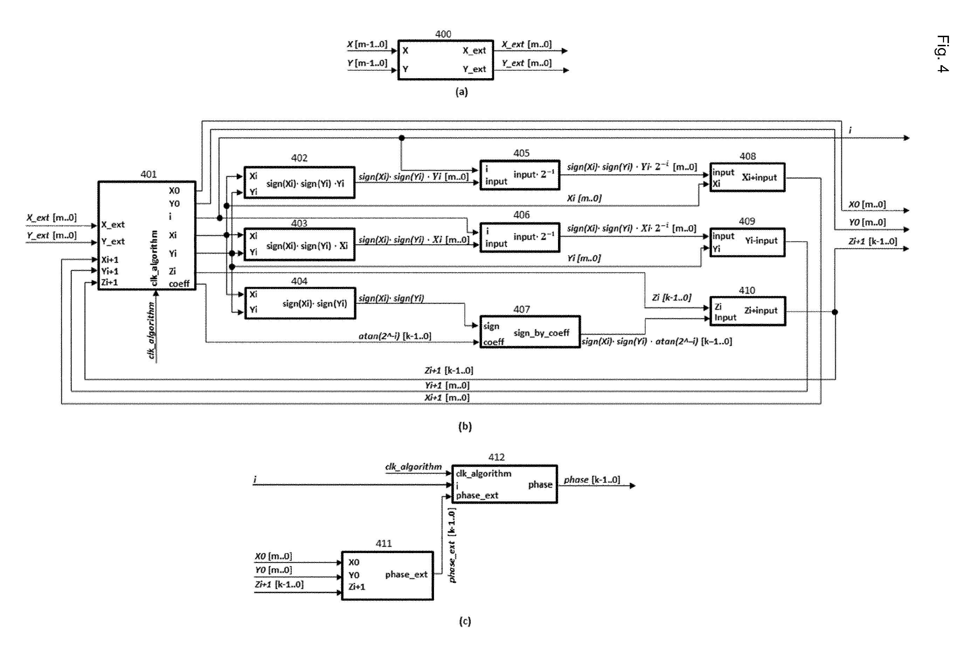

Further, according to an embodiment of the method according to the invention, the CORDIC algorithm is conducted using a field programmable gate array (FPGA). An ASIC (application-specific integrated circuit) could also be used to implement/conduct the principle scheme of the algorithm in fig 4, 5 and 12. Of course, others ways of implementing/conducting the algorithm are also possible.

According to a further embodiment of the method according the invention, said phase shift, preferably a phase shift of an excited system (e.g. a cantilever of an AFM), is evaluated by the lock-in amplifier in a phase locked-loop (PLL), which phase-locked loop comprises said lock-in amplifier, a PID controller (PID), and a numerically controlled oscillator (NCO), wherein the PID controller computes a frequency shift $\Delta\varphi$ PID from the difference $\Delta\varphi$ between a setpoint value $\varphi_{set}$ and said phase shift $\varphi(f)$, and wherein said numerically controlled oscillator (NCO) generates a signal having a frequency that is the sum of a reference frequency $f_{ref}$ and said frequency shift $\Delta\varphi_{PID}$.

Furthermore, an aspect of the present invention relates to a system for estimating a phase shift between an in-phase component and a quadrature component provided by a lock-in amplifier according to claim 9. Particularly, this system is adapted to conduct the method according to the invention. According to claim 1, the system comprises:

- a lock-in amplifier which is configured to provide an in phase component and a quadrature component,
- an arithmetic unit which is configured to receive said components and to estimate said phase (Z) using the in-phase component and the quadrature component by means of a CORDIC algorithm (e.g. see above)

According to a preferred embodiment of the system according to the invention, the arithmetic unit comprises an FPGA for estimating said phase.

According to a further preferred embodiment of the system according to the invention said system further comprises at least one phase-locked loop (PLL), which phase-locked loop (PLL) comprises said lock-in amplifier, a PID controller, and a numerically controlled oscillator. Such a system may be used in conjunction with an AFM (or may comprise an AFM), e.g. in order to maintain constant the phase shift of the transfer function $H(f)$ of a cantilever of the AFM.

Furthermore, the invention relates to a computer program comprising software code which is adapted to conduct the following steps when executed on a computer or on a system according to the invention, or which is adapted to configure (e.g. when being compiled in a bit file) logic elements in an FPGA of a system according to the invention to perform the following steps:

Estimating the phase (Z) using the in-phase component and the quadrature component provided in before by a lock-in amplifier by means of a CORDIC algorithm (see e.g. above).

Further features, embodiments, aspects and advantages of the present invention shall be described by means of a detailed description with reference to the Figures, wherein

Fig.1     shows a block scheme implementing an embodiment of the principle of a lock-in with a phase computed by the CORDIC algorithm

Fig.2     shows a block scheme implementing an embodiment of the principle of a PLL using a lock-in to compute the phase shift and a block scheme implementing an embodiment of a regulation loop using a PLL to maintain constant the phase shift of a system.

Fig.3        shows a diagrammatic illustration of an embodiment of the method or algorithm according to the invention for the computation of the phase;

Fig.4        shows a block scheme implementing an embodiment of the method or algorithm according to the invention with a signed integers representation of the data;

Fig.5        shows a block scheme implementing an embodiment of the method or algorithm according to the invention with a floating representation of the data;

Fig.6        shows a VHDL code describing the structure of the embodiment of Fig.4; wherein parameters of the method/algorithm are 15 coefficients, X and Y of bit-length 16 bits, and a phase of bit-length 19 bits;

Fig.7        shows a functional simulation of the code of Fig.6;

Fig.8        shows a table of phase values computed in the $[\pm 180[$ deg domain with the code of Fig.6 and the atan2 in function of the X and Y components for their comparison, wherein parameters of the method/algorithm are 15 coefficients, X and Y of bit-length 16 bits, and a phase of bit-length 19 bits;

Fig.9        shows a graph comparing the curves of the atan function computed with the code of Fig.6 and the theoretical value of atan in function of the Y/X ratio in the $[\pm 90]$ degrees domain.

Fig.10       shows chronograms showing the restrictions on the clocks;

Fig.11       shows a simulation showing the problem of synchronization of the initial structure of Fig.4.

Fig.12       shows a block scheme of the modified structure of Fig. 4 for its synchronization with an external clock;

Fig.13       shows VHDL code describing the new structure of Fig.12;

Fig.14       shows a functional simulation of the VHDL code of Fig.13; and

Fig.15       shows formulae for the computation of parameters and conversions.

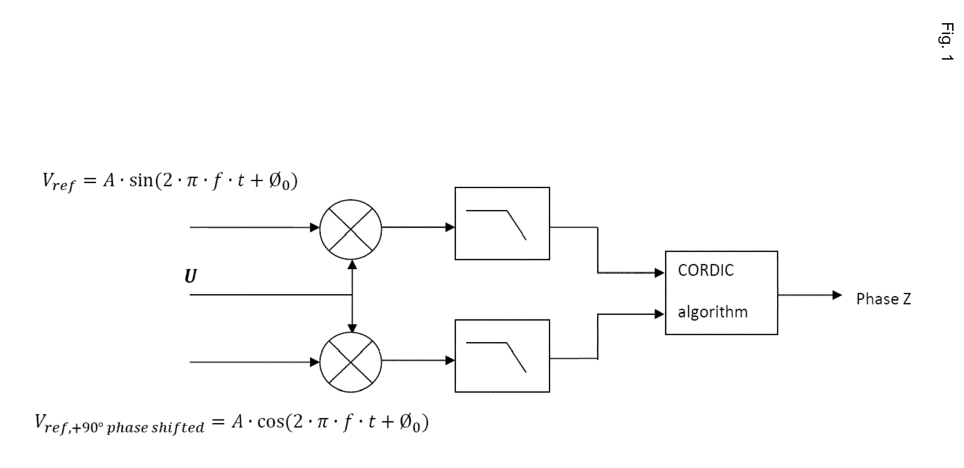

Fig. 1 shows a block scheme implementing an embodiment of the present invention, wherein a lock-in amplifier yields an in-phase component X and a quadrature component Y, wherein the phase difference between these components is computed by the CORDIC algorithm. For this, the following steps are conducted:

-    Providing an input signal $U$ that is sinusoidal,

-    Providing a first reference signal $V_{ref} = A \cdot \sin(2 \cdot \pi \cdot f \cdot t + \emptyset_0)$, wherein particularly $f$ is the frequency of the signal, $A$ is the amplitude of the signal, and $\emptyset_0$ is the phase at the origin,

-    Providing a second reference signal $V_{ref,+90° \, phase \, shifted} = A \cdot \cos(2 \cdot \pi \cdot f \cdot t + \emptyset_0)$ that is +90° phase shifted with respect to the first reference signal $V_{ref}$,

-    Calculating said in-phase component X with the lock-in amplifier, which calculation comprises at least multiplying said first reference signal with the input signal and low-pass filtering the result to yield said in-phase component X,

-    Calculating said quadrature component $Y$ with the lock-in amplifier, which calculation comprises at least multiplying said second reference signal with the input signal and low-pass filtering the result to yield said quadrature component $Y$,

-    Estimating the phase $Z$ using the in-phase component and the quadrature component by means of a CORDIC algorithm.

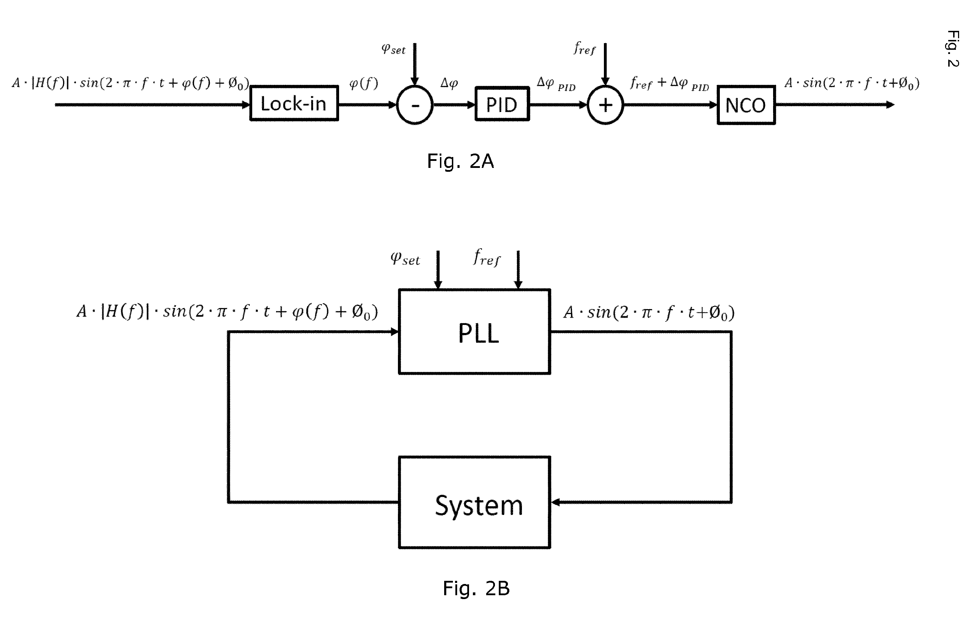

In certain embodiments, as illustrated in Fig. 2, the method according to the invention may be used in conjunction with phase-locked loops (PLL).
PLLs are devices that can maintain a constant phase shift given by a setpoint, between the excitation signal provided by the NCO (Numerically Controlled Oscillator) of the device and the response signal of the excited system. When the phase value differs from the setpoint value (due to a perturbation for example) the PLL adapts the frequency of the excitation signal so that the phase shift corresponds again to the setpoint value.

Most of the PLLs use a lock-in to evaluate this phase-shift. The CORDIC algorithm is in this case well suited for measuring it with high precision.

A simple scheme of the structure of a PLL using a lock-in as phase shift detector is shown in Fig. 2A of Fig. 2, wherein:

$A \cdot \sin(2 \cdot \pi \cdot f \cdot t + \emptyset_0)$ is an excitation signal, wherein $A$ is the amplitude, $f$ is the frequency, $t$ is the time and $\emptyset_0$ the phase at origin;

$A \cdot |H(f)| \cdot \sin(2 \cdot \pi \cdot f \cdot t + \varphi(f) + \emptyset_0)$ is the response signal of the excited system of transfer function $H(f)$ to the excitation $A \cdot \sin(2 \cdot \pi \cdot f \cdot t + \emptyset_0)$ where $|H(f)|$ is the response in amplitude (damping or amplification) and $\varphi(f)$ the phase shift in function of the frequency.

Further, one has:

$\emptyset_0$: phase at origin,

$\varphi_{set}$: setpoint for the phase shift,

$\Delta\varphi$ : phase shift difference between $\varphi_{set}$ and $\varphi(f)$,

$\Delta\varphi_{PID}$: frequency shift computed by the PID controller from $\Delta\varphi$.

$f_{ref}$: reference frequency signal, and

$f_{ref} + \Delta\varphi_{PID}$: new frequency of the excitation signal if the frequency shift is not 0.

This PLL consists of the following components: a lock-in that measures the phase shift $\varphi(f)$ (also denoted Z above) of the excited system, a PID controller (PID) that computes then the frequency shift $\Delta\varphi_{PIP}$ from the difference $\Delta\varphi$ between the setpoint value $\varphi_{set}$ and the measured phase shift $\varphi(f)$, and an NCO (Numerically Controlled Oscillator) that generates a signal which frequency is the sum of the reference frequency $f_{ref}$ and the frequency shift $\Delta\varphi_{PID}$.

Fig. 2B of Fig. 2 shows a regulation loop using a PLL to maintain constant the phase shift of a system having a transfer function $H(f)$. In the case of an AFM (Atomic Force Microscopy) microscope the system is a cantilever of the microscope.

Here, one has:

$\varphi_{set}$: setpoint for the phase shift,

$f_{ref}$: reference frequency of the signal,

$|H(f)|$: response in amplitude of the system, and

$\varphi(f)$: response in phase shift of the system

Further, as explained below, lock-in amplifiers and PLLs may also be used with an AFM in some embodiments of the present invention.

AFM (Atomic Force Microscopy) microscopes use cantilevers with a tip at its end to probe the characteristics of the matter at the nanoscale by measuring the forces that deform its rest shape or disturb its dynamical movement when excited at a specific frequency. The deformations are generally bending or twisting of the cantilever in static mode and the perturbations of the dynamic movement are phase shift variations and damping or amplification variations of the amplitude of the excitation signal for a given frequency.

Before each dynamic measurement the transfer function of the cantilever is measured by the mean of a lock-in. The result is two curves that give the answer of the cantilever in amplitude (damping or amplification of the amplitude of the excitation signal) and phase shift in function of the frequency. From the phase shift curve the quality factor Q of the cantilever can be determined with high precision for a given resonance mode. The value of the quality factor can then be used for instance to compute the optimal gains of the PLL's PID controller.

Another example for the use of lock-ins in AFM is the measurement of interaction forces between the cantilever tip and the sample surface as it is done in PM (Phase Modulation) AFM where the phase shift variations between the excitation signal and the cantilever undergoing the effect of forces for a given frequency is directly proportional to the magnitude of the conservative forces component.

Several modes use also PLLs in dynamic AFM. For instance the non-contact FM (Frequency Modulation) mode used to measure the surface forces on a sample in UHV (Ultra High Vacuum) where the force values are directly proportional to the frequency shift.

Another example is the AFAM (Atomic Force Acoustic Microscopy) where two PLLs are used to track the flexural and torsional contact resonances of the cantilever with its tip in contact with the sample.

A structure for the computation of the phase in the $[\pm\pi[$ rad or $[\pm180[$ deg domain from the two components X and Y is presented Fig.4.

The first part of this structure consists in implementing the three equations for the computation of the atan function with the CORDIC algorithm stated above.

This structure uses a clock *clk_algorithm* to compute on each clock cycle the new components $x_{i+1}$, $y_{i+1}$ and phase values $z_{i+1}$.

After the computation of the phase a module extends the domain of phase values to $[\pm\pi[$ rad or $[\pm180[$ deg by checking the sign of the components X and Y what is done in the second part of the structure.

In the third part of the structure a buffer module displays the phase value after a number of cycles of *clk_algorithm* equal to the number of coefficients needed to compute the phase.

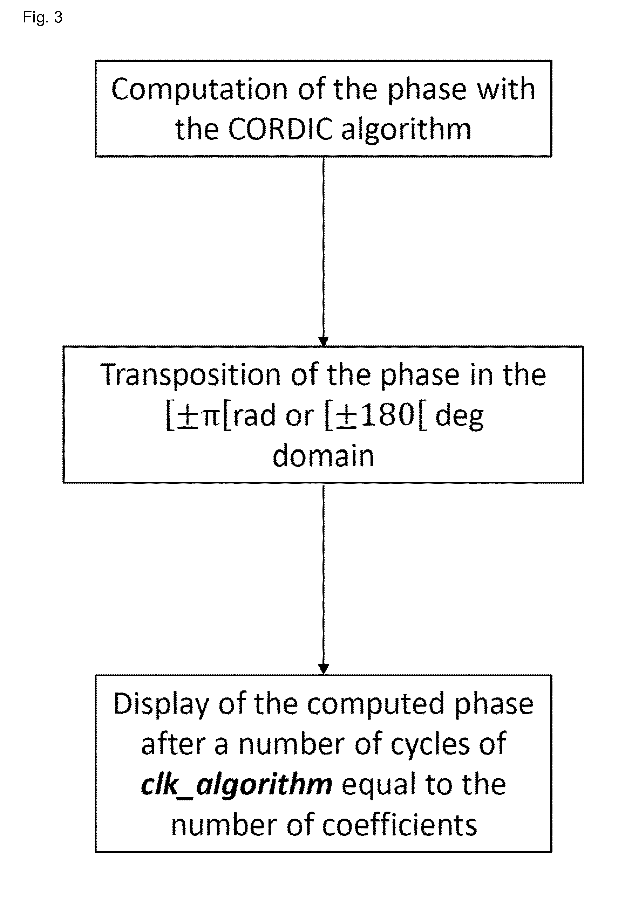

The three steps: computing the phase value with the CORDIC algorithm, extending the value in the $[\pm\pi[$ rad or $[\pm180[$ deg domain and displaying the results after a number of clock cycles equal to the number of coefficients needed to compute the phase are illustrated in Fig. 3.

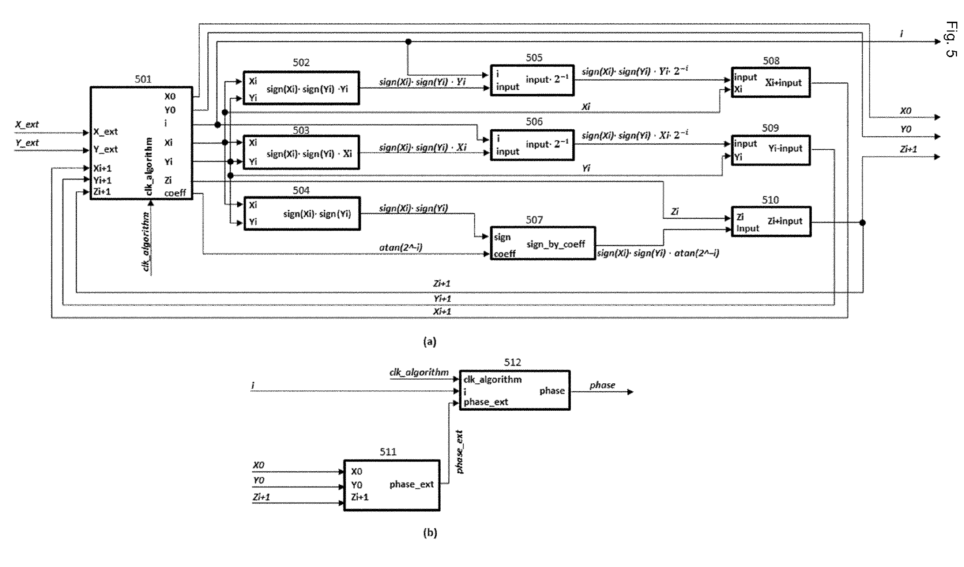

The structure of Fig. 4 is thought for managing a signed integer representation of the data. A similar structure for the floating representation of the data is showed in Fig.5.

The structure of Fig. 4 is thought for being implemented in FPGAs or ASICs.

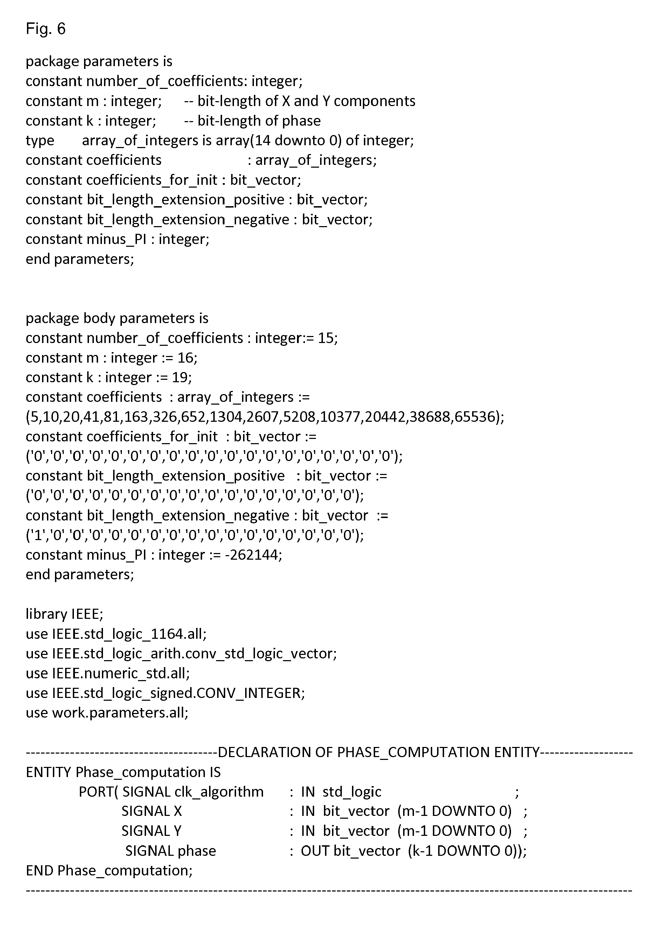

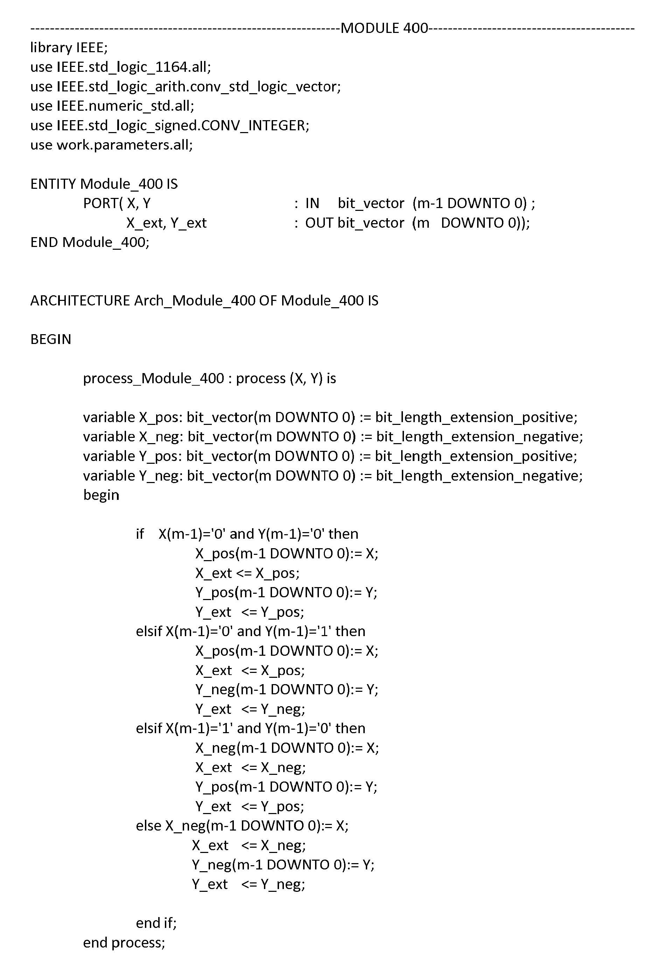

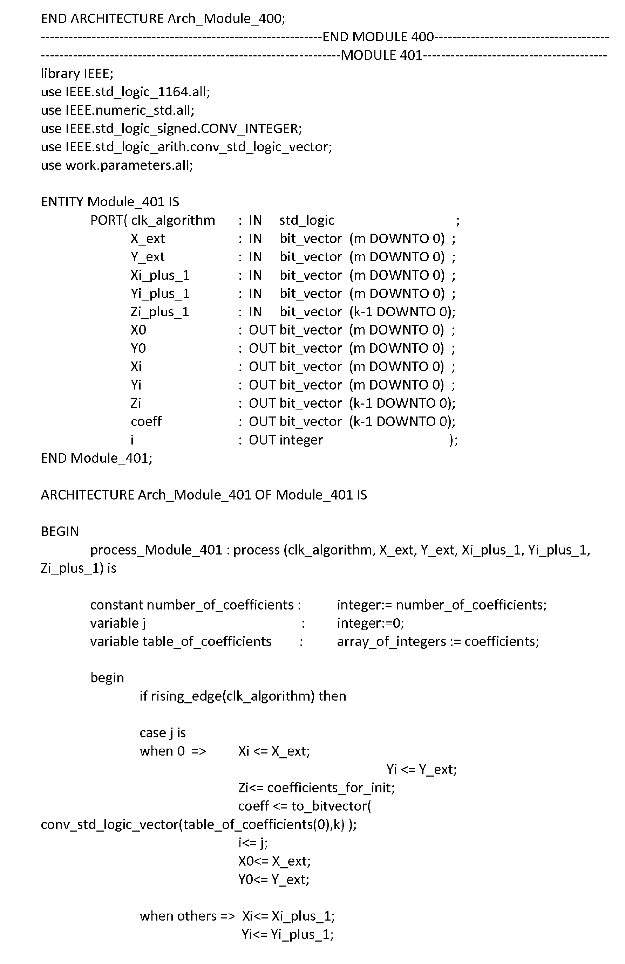

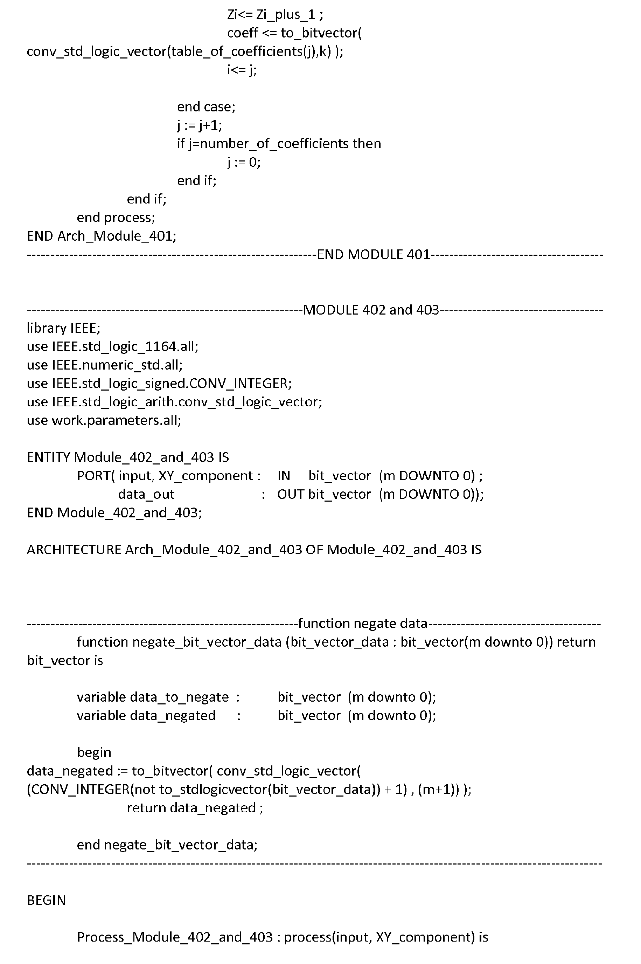

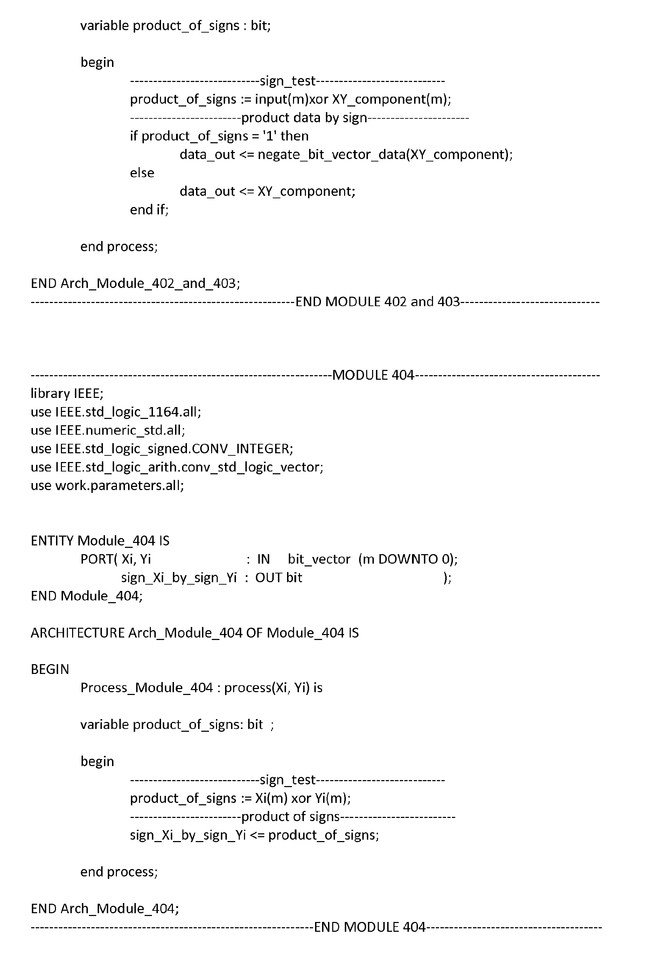

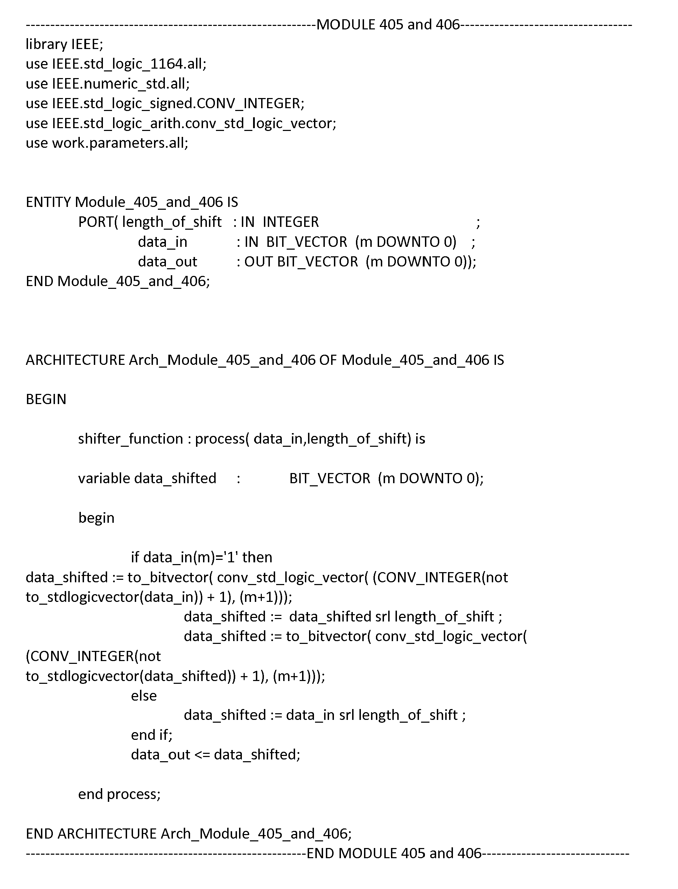

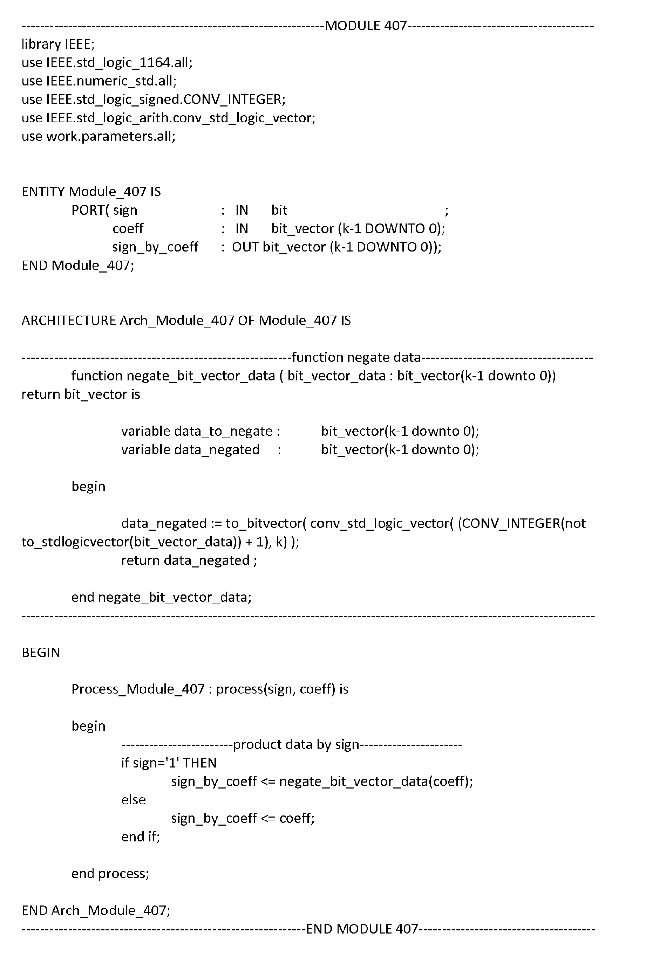

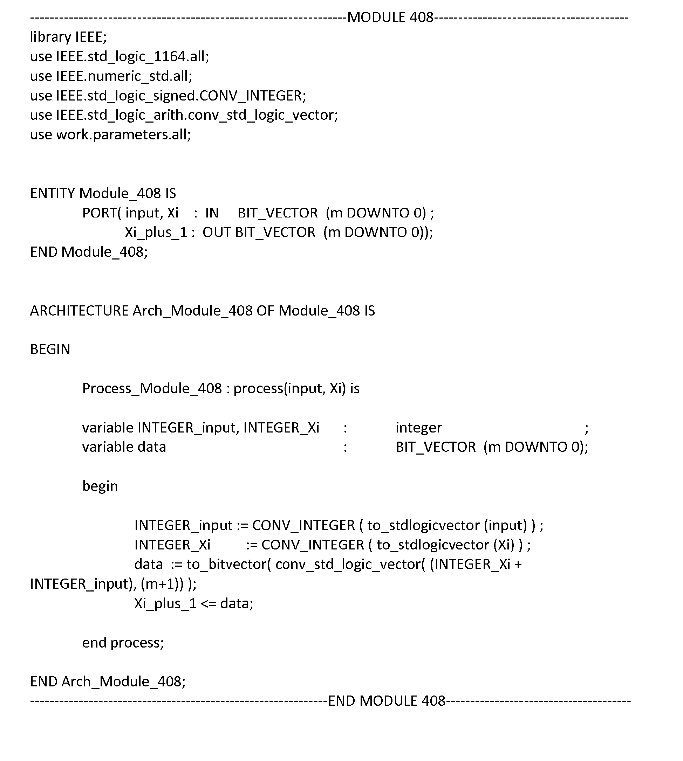

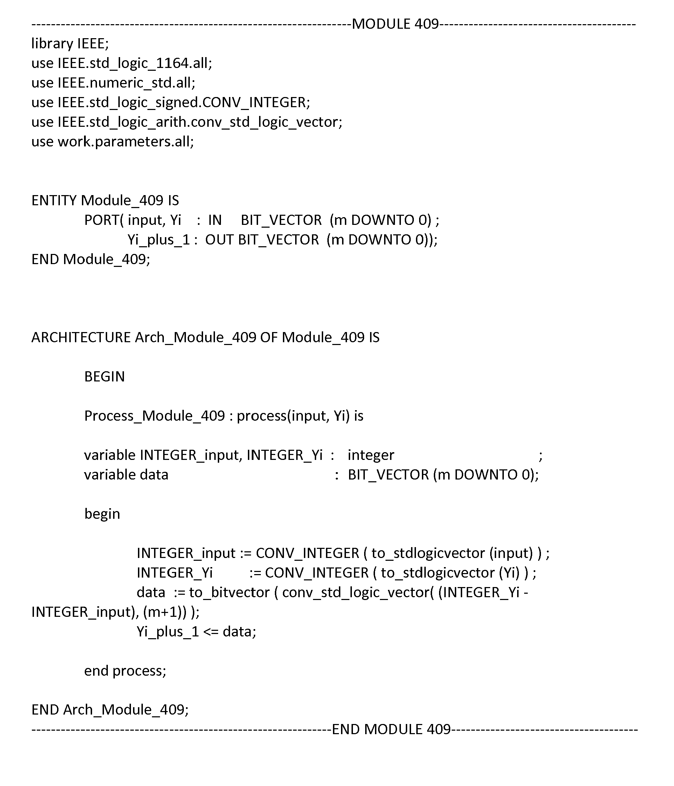

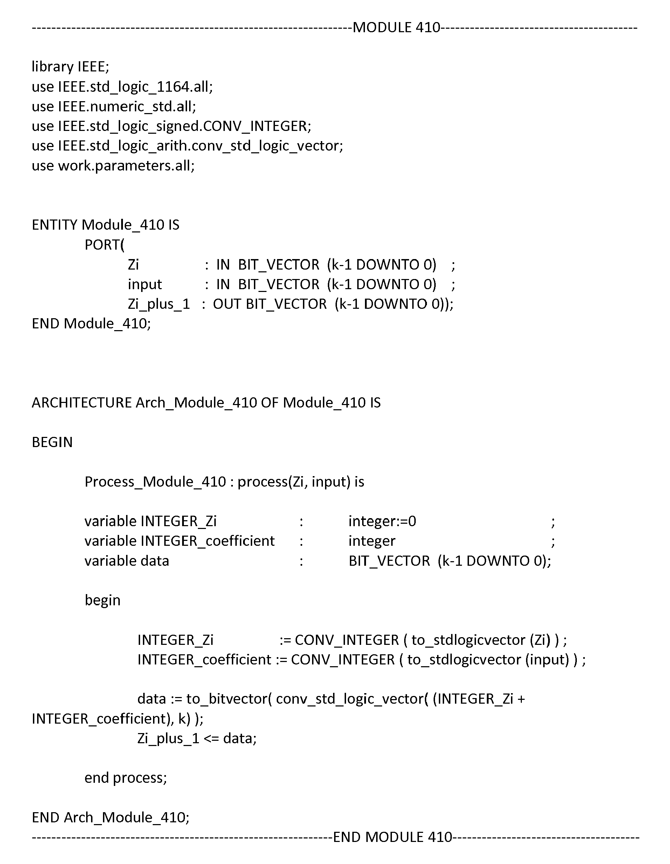

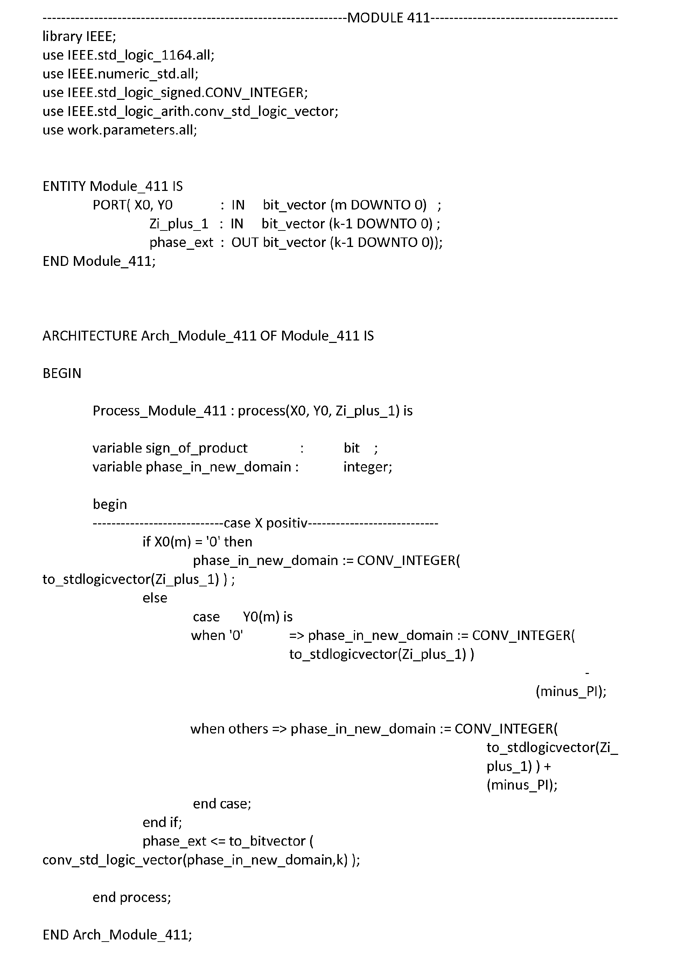

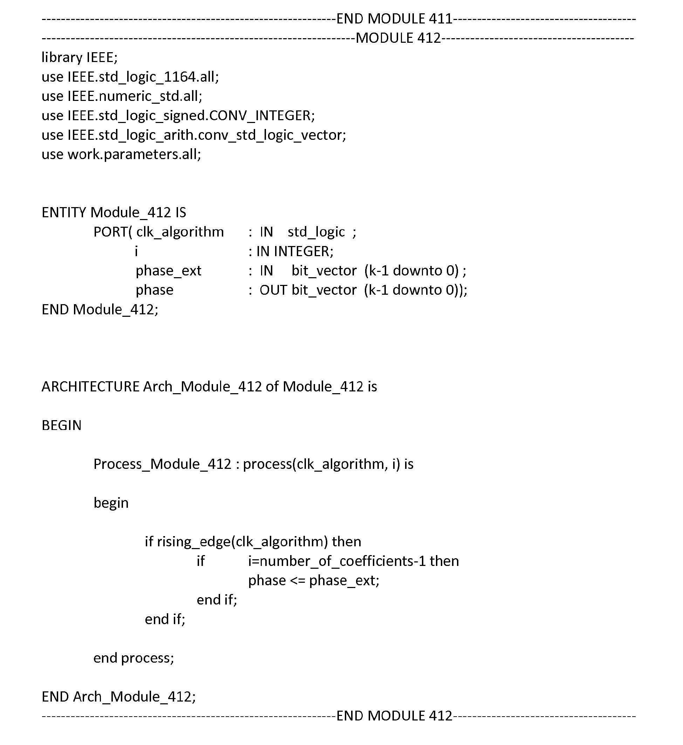

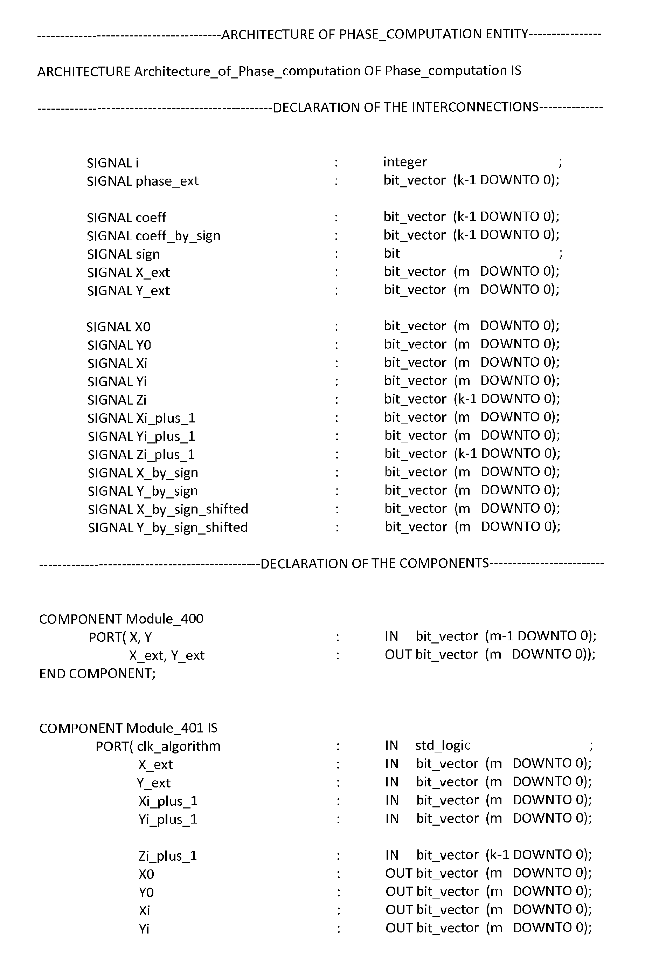

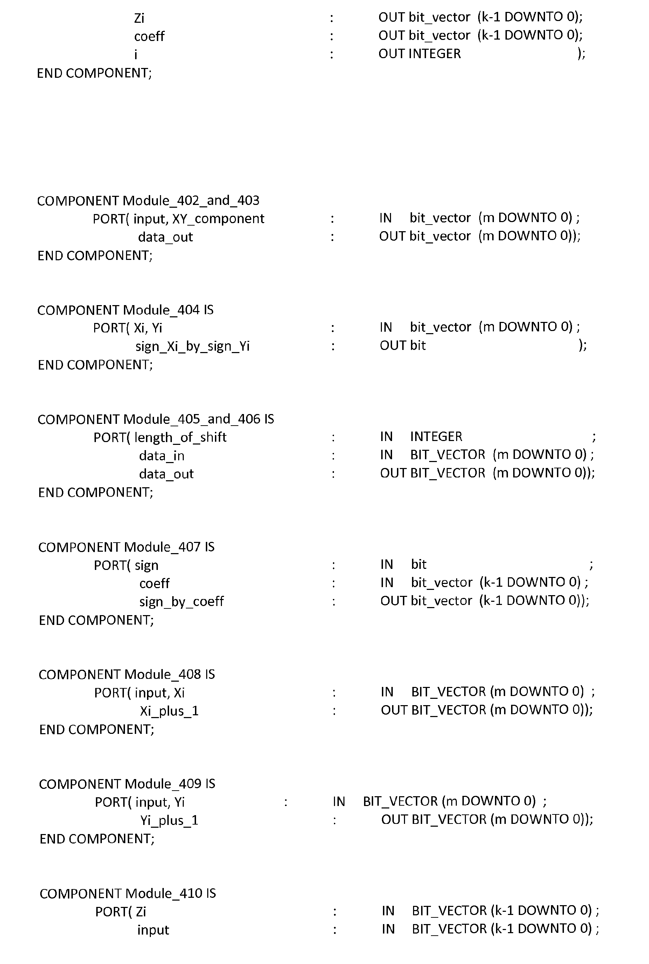

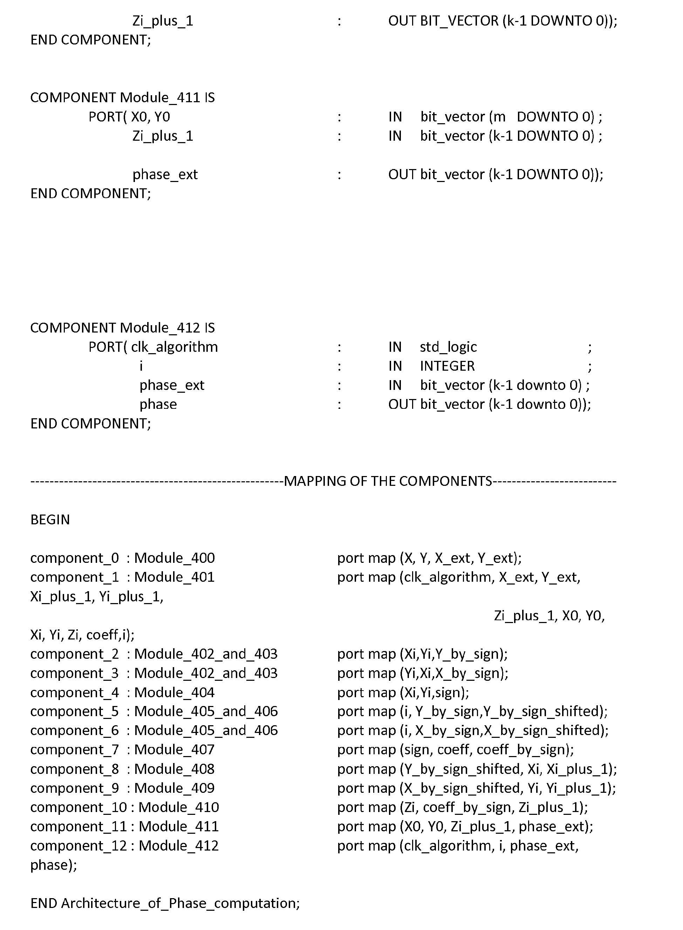

A description in VHDL language of the structure of Fig.4 is proposed in Fig. 6. This code is parameterized in function of the number of coefficients $\tan^{-1}(2^{-i})$ needed together with the bit-length of the components X, Y and the phase. These parameters are set in a package at the start of the code so that every user can configure the code with their own parameters without bringing changes to it. The representation of the data in the code is signed integers and the coefficients $\tan^{-1}(2^{-i})$ need to be adapted to it. This is done by formulas 1500 and 1501. The computed phase is also dimensionless and needs to be calibrated (phase expressed in radians or degrees) when read on a computer what is done by the formulas 1505 and 1506.

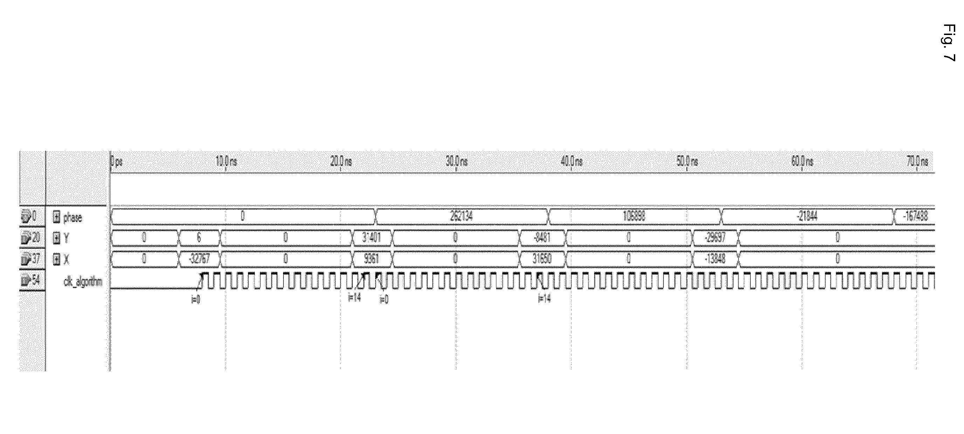

A functional simulation of the algorithm of Fig.6 is illustrated in Fig.7.

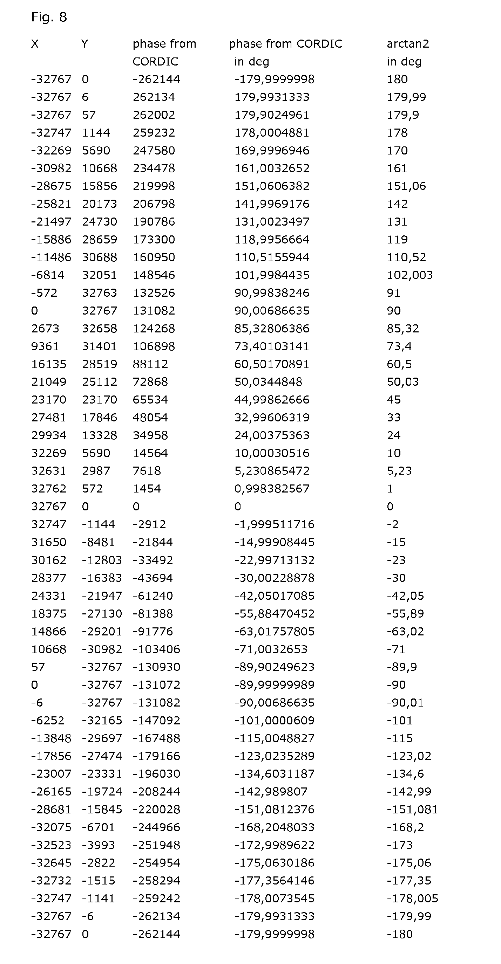

A table of phase values computed in the $[\pm180[$ deg domain with the code of Fig.6 and with atan2 in function of the X and Y components shows the precision of the algorithm of Fig. 6 in figure Fig. 8.

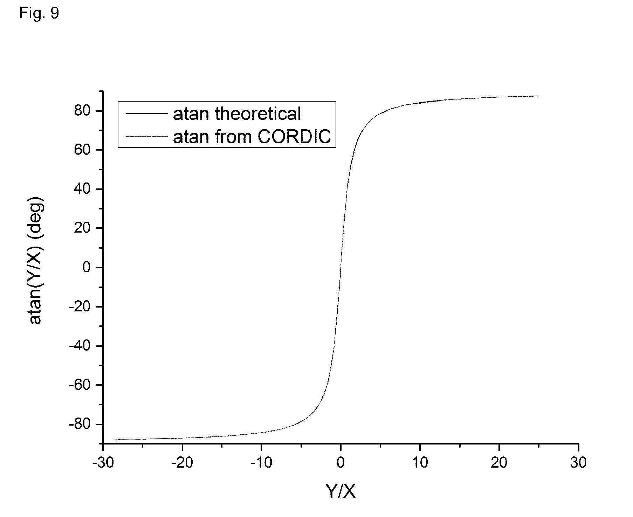

The graph of Fig. 9 comparing the curves of the atan function computed with the code of Fig. 6 and of the theoretical value of atan in function of the Y/X ratio in the $[\pm90[$ deg domain illustrates again the precision of the algorithm.

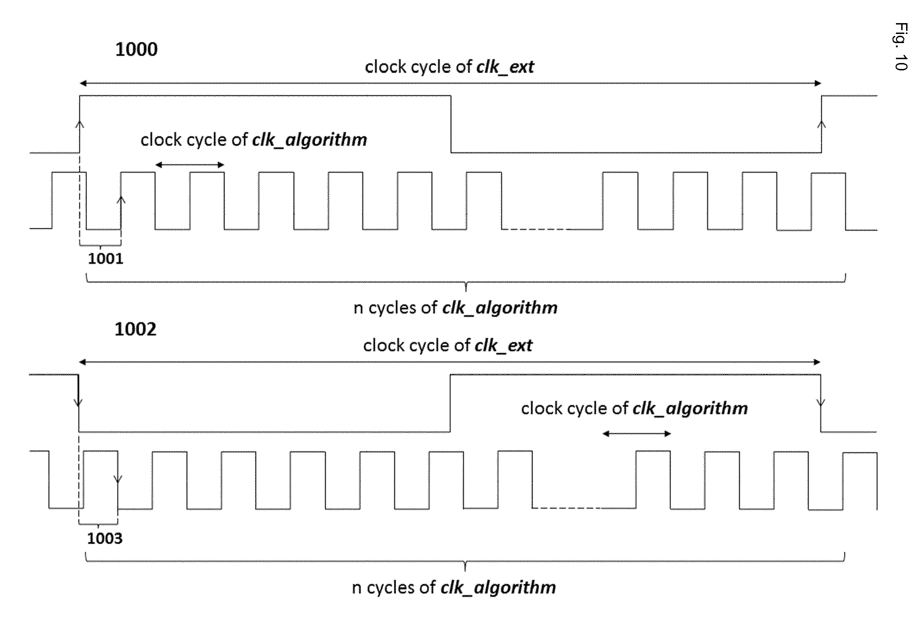

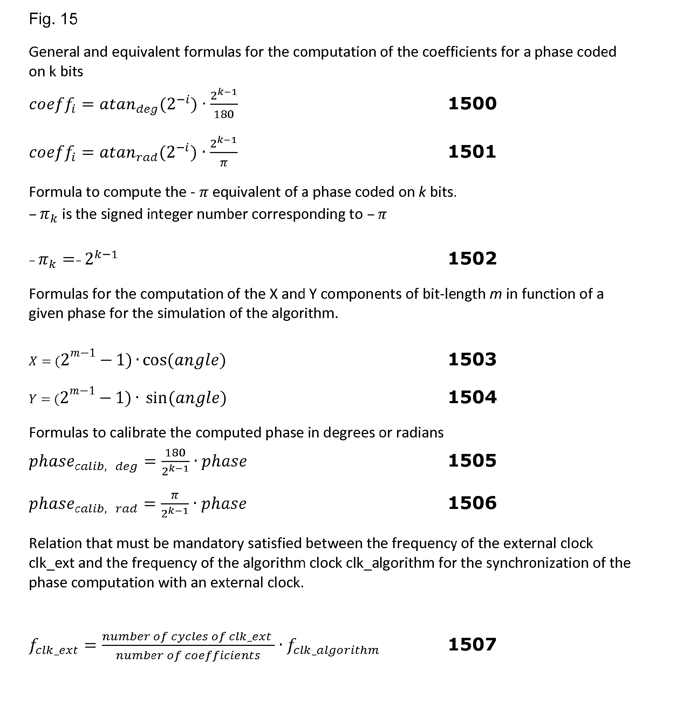

It's generally necessary to synchronize the structure for the phase computation in Fig. 4 with an external clock *clk_ext* of frequency $f_{clk\_ext}$ for example in the case where one wants to determine the phase associated to a couple of components X and Y that are computed every cycles of *clk_ext*. In this case, the phase has to be computed in one cycle of *clk_ext*. That means that after a clock event (rising or falling edge) of *clk_ext* and a small delay (1001 for rising edges and 1003 for falling edges) the algorithm must start to compute on a defined clock event of *clk_algorithm* (rising or falling edge) the phase from the components X and Y as illustrated in the schemes 1000 for rising edges and 1002 for falling edges of Fig. 10. That means also that the frequency of *clk_algorithm* has to be equal to the number of coefficients used by the algorithm multiplied by the frequency of *clk_ext*. This relation between the frequencies is illustrated by the equation 1507 of Fig. 15 where *number of cycles of clk_ext* is taken equal to 1.

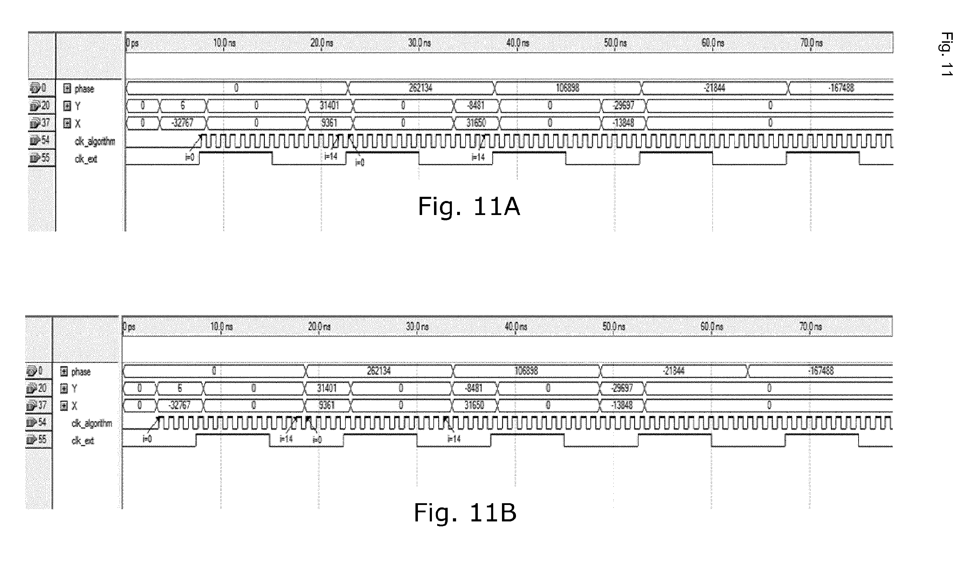

The actual structure of Fig. 4 and the VHDL code describing it in Fig. 6 can compute the phase under these conditions only if the first clock cycle generated for *clk_ext* and *clk_algorithm* satisfy the conditions on the clock events and delays above (chronograms 1000 and 1002) as showed on the functional simulation Fig. 11A. The simulation Fig. 11B illustrates what happens when these conditions are not satisfied. The algorithm starts in this case to compute the phase on the defined clock event of the first generated clock cycle of *clk_algorithm* independently from *clk_ext*.

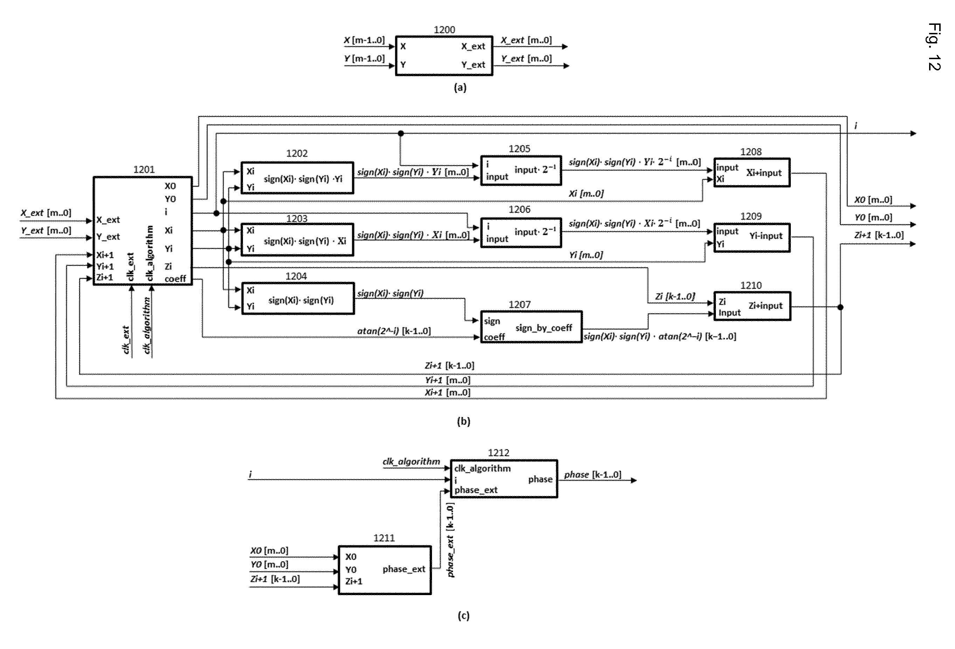

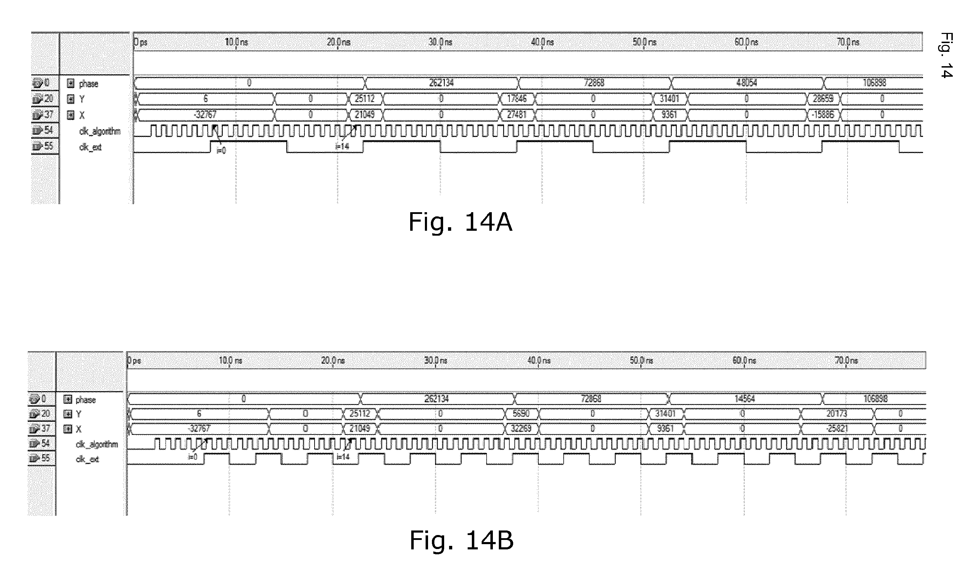

For that reason, a modification of the structure of Fig. 4 and of the code of Fig. 6 is necessary. The modification of the structure consists in adding an input for the external clock *clk_ext* to the MODULE 1201 corresponding to MODULE 401 as illustrated on Fig. 12. With this modification the structure starts the phase computation on the first clock event on *clk_algorithm* that follows a defined clock event on the first generated cycle of *clk_ext* as showed on Fig. 14A and Fig. 14B.

This general algorithm can also be used for a phase computation on more than one cycle of *clk_ext*. This can for example be the case when it's not possible to synthesize a *clk_algorithm* clock with a frequency that can satisfy the equation 1507 for a fixed number of coefficients and clock frequency of *clk_ext* and a number of cycles of *clk ext*=1. In this case the number of cycles of *clk_ext* has to be enhanced in order that the equation 1507 is satisfied.

In the following, the figures are described in more detail in the context of the present invention.

Fig. 3 shows the algorithm for the computation of the phase from the X and Y components computed by a lock-in amplifier.

Fig. 4 shows the block scheme of a structure implementing the algorithm specified in Fig. 3. This structure is thought for a signed integer representation of the X, Y components and the phase. This scheme can also be used for a floating representation of the data. In this case the Block 400 is ignored and the components X_ext [m..0] and Y_ext [m..0] are now simply called X and Y for a question of coherence as X_ext [m..0] and Y_ext [m..0] are X and Y with a bit-length increased by 1. This structure for floating numbers is represented in Fig. 5.

Block 400: as stated above increases the bit-length m of the X [m-1..0] and Y [m-1..0] components by 1. This module avoids problems of overflow that can appear in Block 408 and 409. X_ext [m..0] resp. Y_ext [m..0] are the extended components X [m-1..0] resp. Y[m-1..0].

Block 401: every clock cycle of *clk_algorithm* it puts the previously computed values Xi+1[m..0], Yi+1[m..0],

Zi+1[k-1..0] on the outputs Xi, Yi, Zi. It computes also the new iteration i and outputs it together with the corresponding coefficient *coef f $_i$*[k-1..0]. When i=0 it assigns the values X_ext [m..0] resp. Y_ext [m..0] to the outputs X0 resp. Y0 and *Xi* resp. *Yi*.

Block 402: computes the product *sign(Xi) · sign(Yi) · Yi* [m..0].

Block 403: computes the product *sign(Xi) · sign(Yi) · Xi* [m..0].

Block 404: computes the product *sign(Xi) · sign(Yi)*.

Block 405: computes the product *sign(Xi) · sign(Yi) · Yi·* $2^{-i}$ [m..0].

Block 406: computes the product *sign(Xi) · sign(Yi) · Xi·* $2^{-i}$ [m..0].

Block 407: computes the product *sign(Xi) · sign(Yi) · coeff $_i$* [k-1..0].

Block 408: computes *Xi+1* [m..0] by adding *sign(Xi) · sign(Yi) · Yi·*$2^{-i}$ [m..0] to *Xi* [m..0].

Block 409: computes *Yi+1* [m..0] by subtracting *sign(Xi) · sign(Yi) · Xi·* $2^{-i}$ [m..0] to *Yi* [m..0].

Block 410: computes *Zi+1* [k-1..0] by adding *sign(Xi) · sign(Yi) · coeff $_i$* [k-1..0] to *Zi* [k-1..0].

Block 411: extends the *Zi+1* [k-1..0] value to the equivalent to [±180[ deg domain by checking the sign of *X0* [m..0] and *Y0* [m..0].

Block 412: on a clock event on *clk_algorithm* if i=number of coefficients-1, it puts the *phase_ext* [k-1..0] value to the phase output.

The names written in italic correspond to the signals.

The brackets give information about the bit-length of the data. The bit-length of a name without brackets is 1 bit or an integer value (case of iteration i) with a bit-length that can be chosen by the user.

Fig. 5 shows a block scheme based on the one on Fig. 4 implementing the algorithm of Fig. 3 with a floating representation of the data.

Further, Fig. 6 describes the structure of Fig. 4 and the behavior of its modules with the VHDL language.

This code can be simulated and implemented in a FPGA after compilation.

The language used is VHDL and the code's edition together with the functional simulation of Fig. 7 were done with the QUARTUS II 9.1 Web edition software.

The representation of the data is signed integer.

The code is general and can be easily parameterized in function of the number of coefficients and the bit-length of the components X, Y and the phase by defining these parameters in the package structure called *parameters* on the top of the code.

The clock event on *clk_algorithm* used for the computation is rising edge.

For a number of coefficients **n**, a components bit-length of **m** and a phase bit-length of **k** the package *parameters* is defined as following

package parameters is

constant number_of_coefficients: integer;

constant m : integer; -- bit-length of X and Y components

constant k : integer; -- bit-length of phase

type array_of_integers is array(n-1 downto 0) of integer;

constant coefficients : array_of_integers;

constant coefficients_for_init: bit_vector;

constant bit_length_extension_positive : bit_vector;

constant bit_length_extension_negative : bit_vector;

constant minus_PI : integer;

end parameters;

package body parameters is

```
constant number_of_coefficients : integer:= n;
constant m : integer:= m;
constant k : integer:= k;
constant coefficients : array_of_integers := (coeff_{n-1}, coeff_{n-2,...}, coeff_0,);
constant coefficients_for_init : bit_vector := ('0',... ,'0'); --bit-length k
--The constant coefficients_for_init contains a number of k '0'
constant bit_length_extension_positive : bit_vector:= ('0','0','0',..,'0'); --bit-length m+1 --consists of m+1 '0'
constant bit_length_extension_negative : bit_vector:= ('1','0','0',.. ,'0'); --bit-length m+1
--consists of '1' on the end and m '0' before
constant minus_PI : integer:= -2^{k-1};
end parameters;
```

The phrases preceded by -- are comments.

The parameters used in the package of the code of Fig. 6 correspond to a number of coefficients of 15 and a bit-length of 16 for the X and Y components and 19 for the phase value.

The constant *coefficients_for_init consists* of k '0' and must be adapted in function of the bit-length of the phase.

The constant *bit_length_extension_positive* consists of m+1 '0' and must be adapted in function of the bit-length of the components X and Y.

The constant *bit_length_extension_negative* consists of a '1' for the MSB (Most Significant Bit) and m '0' and must be adapted in function of the bit-length of the components X and Y.

The names written in italic in the description correspond to the data of Fig. 4.

A module followed by a number from 400 to 412 describes a block with the same number of Fig. 4.

Two modules MODULE 402 and 403 resp. MODULE 405 and 406 describe the same blocks Block 402 and Block 403 resp. Block 405 and Block 406.

The actual code uses the parameters n=15, m=16 and k=19.

MODULE 400: extends the bit-length m of the components X[m-1..0] and Y[m-1..0] by +1.

It has 2 inputs X, Y and 2 outputs X_ext, Y_ext. 4 constants are used to build the extended components in function of their signs.

The bit-length of the 4 constants is m+1.

X_pos: is used to build X_ext when X is positive.

X_neg: is used to build X_ext when X is negative.

Y_pos: is used to build Y_ext when Y is positive.

Y_neg: is used to build Y_ext when Y is negative.

The components are built by the following way.

The sign of X and Y is first tested by checking the value of their MSB (Most Significant Bit).

If X and Y are positive:

The m bits of X are assigned to the m first bits of X_pos.

The same thing is done for Y_ext at the difference that the m bits of Y are assigned to the m first bits of Y_pos.

Then X_pos resp. Y_pos are put on X_ext resp. Y_ext.

If X is positive and Y negative:

The m bits of X are assigned to the m first bits of X_pos and the m bits of Y to the m first bits of Y_neg.

Then X_pos resp. Y_neg are put on X_ext resp. Y_ext.

If X and Y are negative:

The m bits of X are assigned to the m first bits of X_neg.

The same thing is done for Y_ext at the difference that the m bits of Y are assigned to the m first bits of Y_neg.

Then X_neg resp. Y_neg are put on X_ext resp. Y_ext.

If X is negative and Y positive:

The m bits of X are assigned to the m first bits of X_neg and the m bits of Y to the m first bits of Y_pos.

Then X_neg resp. Y_pos are put on X_ext resp. Y_ext.

MODULE 401: for every clock cycles on a defined event (high edge for example) of *clk_algorithm* it puts the value Xi_plus_1, Yi_plus_1, Zi_plus_1on the outputs Xi, Yi and Zi. It computes also the new iteration i and outputs it together with the corresponding coefficient *coeff $_i$*. When i=0 it assignes the values X_ext resp. Y_ext to the outputs X0 resp. Y0 and Xi resp.Yi.

It has 6 inputs and 7 outputs.

X_ext and Y_ext are the inputs for respectively the components X_ext[m..0] and Y_ ext [m..0] in Fig. 4.

Xi_plus_1, Yi_plus_1, Zi_plus_1 are the inputs for the new *Xi* [m..0] and *Yi* [m..0] components and the phase value *Z_i* [k-1..0] computed during the previous iteration.

clk_algorithm is the input for the clock that synchronizes the module

i is the output for the iteration value *i*.

Xi, Yi, Zi is the output for the new *Xi* [m..0], *Yi* [m..0], *Zi* [k-1..0] of the new iteration.

coeff is the output for the coefficient value equivalent to arctan(2^-i) at iteration *i*.

The module has 1 constant and 2 internal variables. The constant number_of_coefficients corresponds to the parameter **n**.

The internal variable j corresponds to the value of an iteration and is initialized with 0.

The internal variable *table_of_coefficients* is an array that contains the n coefficient values equivalent to arctan(2^-*i*) with $i \in$ {0, ..., *n* - 1}.

The value of the coefficients is computed with the equations 1500 or 1501.

Every event on the clock, if the iteration j is 0 then the values on the inputs X_ext and Y_ext are put resp. on the outputs Xi and Yi, X0 and Y0. The value 0 is put on Zi, the value 0 on the output i and the coefficient value equivalent to arctan(1) on output coeff.

If the iteration is different from 0, the inputs Xi+1, Yi+1 and Zi+1 are put on resp. the outputs Xi, Yi and Zi, the value of j on the output i and the coefficient value corresponding to arctan(2^-*i*) on the output coeff.

Then the value of the internal variable j is incremented by 1. If this value equals n(number of coefficients) then j is reinitialized to 0.

MODULE 402 and 403: computes *sign(Xi) · sign(Yi) · Yi* [m..0] (block 402) and *sign(Xi) · sign(Yi) · Xi* [m..0] (block 403).

This module is used to describe the blocks 402 and 403.

It has 2 inputs and one output.

input and XY_component are the inputs for respectively *Xi* [m..0] and *Yi* [m..0] in Fig.4.

data_out returns *sign(Xi) · sign(Yi) · Yi* [m..0] in the case of the block 402 and *sign(Xi) · sign(Yi) · Xi* [m..0] in the case of the block 403.

The module performs the product sign(Xi) · sign(Yi) · Yi for 402 and sign(Xi) · sign(Yi) · Xi for 403.

In the code the product of the signs is done by applying a xor function to the MSB (Most Significant Bit) of input and XY_component (Xi and Yi).

if the result is negative then the function negate_bit_vector_data negates the input XY_component (corresponding to Yi for 402 and Xi for 403) and puts the result on data_out.

Else XY_component is put directly on data_out.

MODULE 404: performs the product of the signs of *Xi* [m..0] and *Yi* [m..0].

It has 2 inputs and one output.

Xi and Yi are respectively the inputs for the *Xi* [m..0] and *Yi* [m..0] components.

sign_Xi_by_sign_Yi is the output for the result of the operation completed by the module 404.

It computes *sign(Xi) ·* sign(Yi) by applying a xor function to the most significant bit of Xi and Yi.

MODULE 405 and 406: computes *sign(Xi) · sign(Yi) · Yi ·* **2⁻ⁱ** [m..0] (block 405) and *sign(Xi) · sign(Yi) · Xi ·* **2⁻ⁱ** [m..0] (block 406).

This module is used to describe the blocks 405 and 406.

It has 2 inputs and one output.

length_of_shift is the input for the iteration value *i*.

data_in is the input for *sign(Xi) · sign(Yi) · Yi* [m..0] in the case of block 405 and for *sign(Xi) · sign(Yi) · Xi* [m..0] in the case of block 406.

data_out is the output for sign(*Xi*) · sign(*Yi*) · *Yi ·* **2⁻ⁱ** [m..0] in the case of block 405 and for sign(*Xi*) · sign(*Yi*) · *Xi·* **2⁻ⁱ** [m..0] in the case of block 406.

A variable data_shifted is also used.

sign(*Xi*) · sign(*Yi*) · *Yi·* **2⁻ⁱ** [m..0] and sign(*Xi*) · sign(*Yi*) · *Xi·* **2⁻ⁱ** [m..0] are computed by shifting right data_in by a number of bits specified by length_of_shift. This shift is done with the operator srl.

As this operator can only shift positive numbers the sign of data_in is checked every time.

If the sign is negative data_in is first complemented by 2 to get a positive value and saved in data_shifted. data_shifted is shifted with srl and saved in data_shifted. Finaly data_shifted is complemented by 2 again to get the negative value rightly shifted and saved in data_shifted.

If data_in is positive it is directly shifted with srl and saved in data_shifted.

Once the shift is done data_shifted is assigned to data_out.

MODULE 407 computes *sign(Xi) · sign(Yi)· arctan(2^-i)* [k-1..0].

It has 2 inputs and one output.

sign is the input for the result of the product *sign(Xi) · sign(Yi).*

coeff is the input for the coefficient value *arctan(2^-i)* [k-1..0].

sign_by_coeff is the output for the product *sign(Xi) · sign(Yi)· arctan(2^-i)* [k-1..0].

The module returns the value of the product *sign(Xi) · sign(Yi)· arctan(2^-i)* [k-1..0].

The operation is done by checking the sign of the input sign.

If sign is negative the function negate_bit_vector_data negates the input coeff and assigns the result to the output sign_by_coeff.

Else the input coeff is directly assigned to the output sign_by_coeff.

MODULE 408 computes the new component *Xi+ 1* [m..0].

It has 2 inputs and one output.

input is the input for the product *sign(Xi) · sign(Yi) · Yi· 2^{-i}* [m..0].

Xi is the input for the *Xi* [m..0] component.

Xi_plus_1 is the output for the result of the addition of input to Xi. The result corresponds to *Xi+sign(Xi) · sign(Yi) · Yi· 2^{-i}* [m..0].

MODULE 409: computes the new component Yi+ 1 [m..0].

It has 2 inputs and one output.

input is the input for the product *sign(Xi) · sign(Yi) · Xi· 2^{-i}* [m..0].

Yi is the inputs for the *Yi* [m..0] component.

Yi_plus_1 is the output for the result of the subtraction of input to Yi. The result corresponds to

$$Yi\text{-}sign(Xi) \cdot sign(Yi) \cdot Xi \cdot 2^{-i} \ [\mathrm{m}..0].$$

MODULE 410: computes the new phase *Zi+1* [k-1..0].

It has 2 inputs and 1 output.

Zi is the input for the *Zi* [k-1..0] phase value at iteration i.

input is the input for *sign(Xi) · sign(Yi)· arctan(2^-i)* [k-1..0].

*Zi+1* is the output of the result of the operation completed by the module.

The operation is done by adding the input Zi to the input input.

MODULE 411 transposes the phase value *Zi+1* [k-1..0] to the$[\pm\pi[$ rad or $[\pm 180[$ deg domain.

It has 3 inputs and 1 output.

X0 and Y0 are the inputs for respectively the extended components X0 [m..0] (*X_ext* [m..0]) and *Y0* [m..0] (*Y_ext* [m..0]) from which we want to compute the phase with the algorithm.

Zi_plus_1 is the input of the phase value *Zi+1* [k-1..0] computed with the CORDIC algorithm.

phase_ext is the output of the phase transposed in the $[\pm\pi[$ rad or $[\pm 180[$ deg domain.

The sign of X0 is checked since X0 positive corresponds to a phase value in the $\left[\pm\dfrac{\pi}{2}\right]$ rad or $[\pm 90]$ deg domain.

In the case X0 $\geq$0 the phase value belongs to the interval $\left[\pm\dfrac{\pi}{2}\right]$ rad or $[\pm 90]$ deg. In this case phase_ext is assigned to Zi+1.

In the case X0 < 0, the phase value belongs to the extended domain. If Y0 >0 then $\pi$ rad or 180 deg has to be added to the phase value, phase_ext = Zi+1 + $2^{k-1}$, else - $\pi$ rad or -180 deg has to be added, phase_ext = Zi+1 - $2^{k-1}$. In the algorithm Zi+1 + $2^{k-1}$ is done by subtracting -$\pi$ rad or -180 deg to Zi+1 for a question of maximum of resolution.

With a phase represented with signed integer and with a bit-length of k one can have values from -$2^{k-1}$ to ($2^{k-1}$ - 1).

These values are used to represent the interval $[\pm\pi[$ rad or $[\pm 180[$ deg. Hence the value $\pi$ rad or 180 deg can't be represented but this can be done with - $\pi$ rad or -180 deg. Hence adding $\pi$ rad or 180 deg is equivalent to subtracting - $\pi$ rad or -180 deg.

MODULE 412 outputs the phase value in function of the input i

It has 3 inputs and 1 output.

clk_algorithm is the input for the algorithm clock

i is the input for the iteration *i*. This input permits the synchronization of the blocks 401 and blocks 412 so that when the $n^{th}$ iteration happens, the blocks 412 knows that the right phase value has to be output.

phase_ext is the input for the extended phase value.

phase is the output for the result of the operation completed by the module.

On high or low edges of the clock if the value on the input i corresponds to n-1 (with n the number of coefficients used for computing the phase) then the new phase value on phase_ext is put on the output phase.

After the description of the modules, the architecture of the structure is defined, its name is ARCHITECTURE OF PHASE_COMPUTATION. First the components corresponding to them together with the signal that will interconnect them are declared in the parts DECLARATION OF THE INTERCONNECTIONS and DECLARATION OF THE COMPONENTS. After this step the components are interconnected as described in Fig. 4 in the MAPPING OF THE COMPONENTS part.

Fig. 7 shows a functional simulation of the code of Fig.6 with the parameters n=15, m=16 and k=19.

The period of the clock is 1 ns. The computed phase from the X and Y values on i=0 is displayed after 15 periods.

The correctness of the values can be checked from the results in the table of values of Fig. 8.

Fig. 8 shows a table of phase values computed in the [$\pm$180[ deg domain with the code on Fig. 6 and the atan2 function in function of the X and Y components for their comparison. The parameters of the code are

- 15 coefficients

- X and Y of bit-length 16 bits

- phase of bit-length 19 bits

The X and Y components are built from the parameters and the equations 1503 and 1504 for a specified angle corresponding to the phase. The computed value is then calibrated in degrees with 1505. The result of the atan for given X and Y components gives exactly the angle value.

Fig. 9 shows a graph comparing the curves of the atan function computed with the code of Fig. 6 and the theoretical value of atan in function of the Y/X ratio in the [$\pm$90] degrees domain.

Fig. 10 shows the restriction on the clock signals *clk_ext* and *clk_algorithm* for their synchronization. The synchronization is based on the rising (1000) and falling (1002) edges of the clocks. On a rising resp. falling edge on *clk_ext* the computation of the phase is started after a rising resp. falling edge on *clk_algorithm*. A delay 1001 resp. 1003 between the rising resp. falling edges of *clk_ext* and *clk_algorithm* is necessary. This delay mustn't be higher than a cycle of *clk_algorithm*. The best delay is half of a cycle of *clk_algorithm*.

Fig. 11 shows a simulation showing the problem of synchronization of the initial structure of Fig. 4.

Graph 11A of Fig. 11 clk_algorithm and *clk_ext* synchronized.

Graph 11B of Fig. 11 *clk_algorithm* and *clk_ext* not synchronized. The start of the computation of the phase is not synchronized with the rising edge of *clk_ext*.

Fig. 12 shows a block scheme of the modified structure of Fig. 4 for its synchronization with an external clock. The external clock *clk_ext* is added to MODULE 1201.

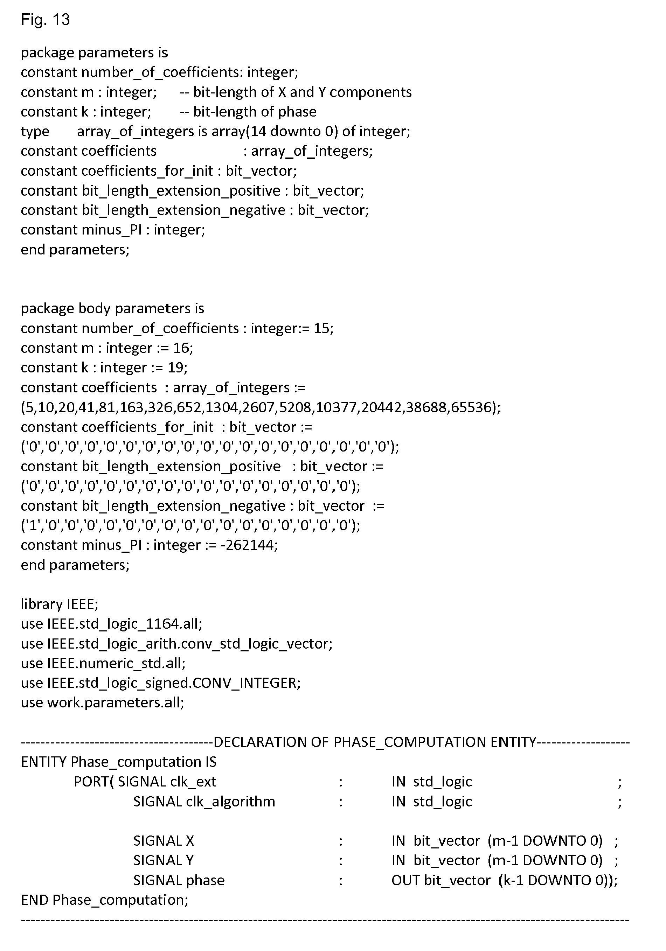

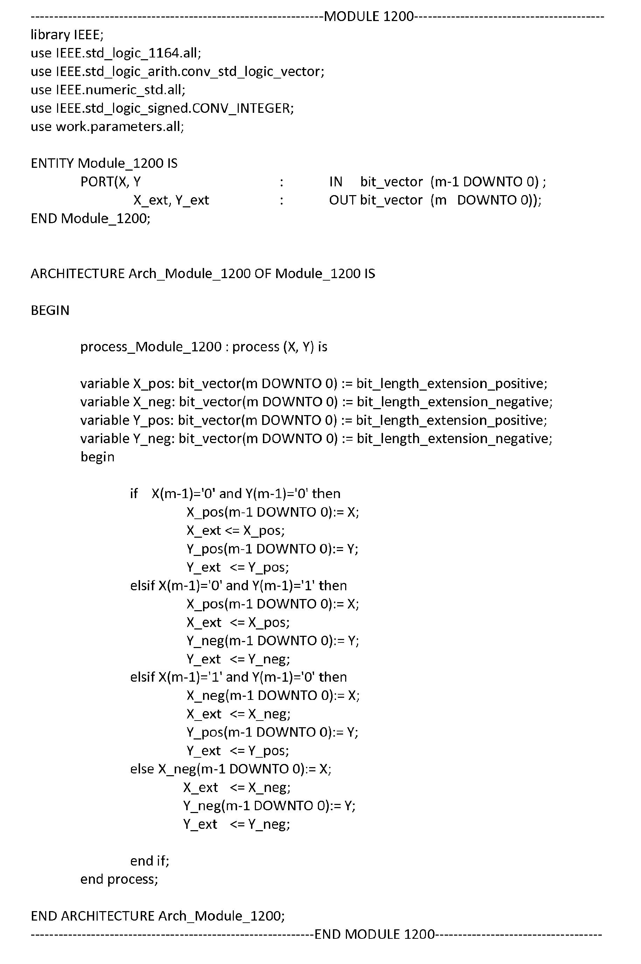

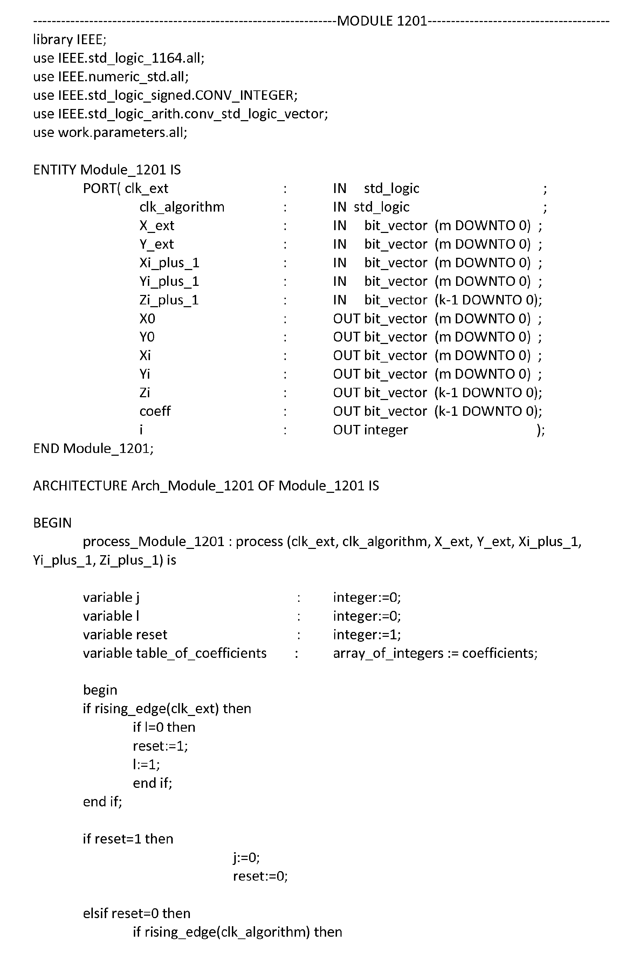

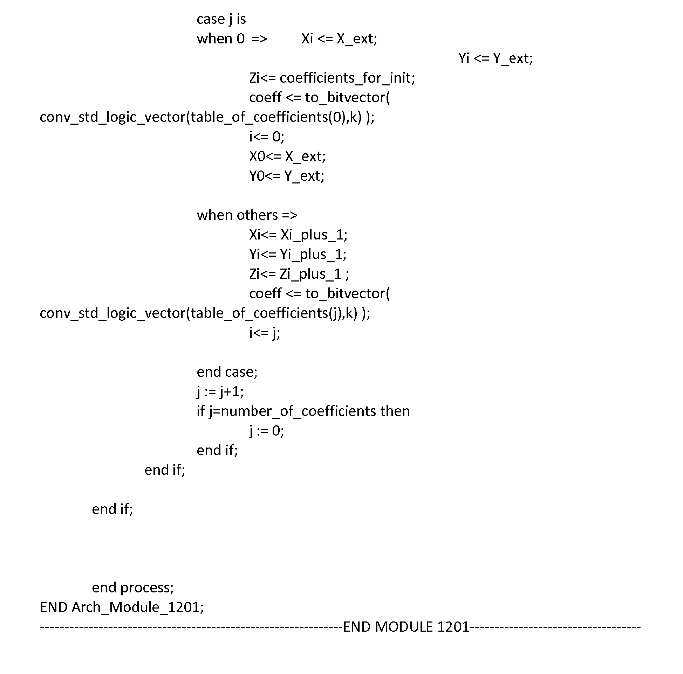

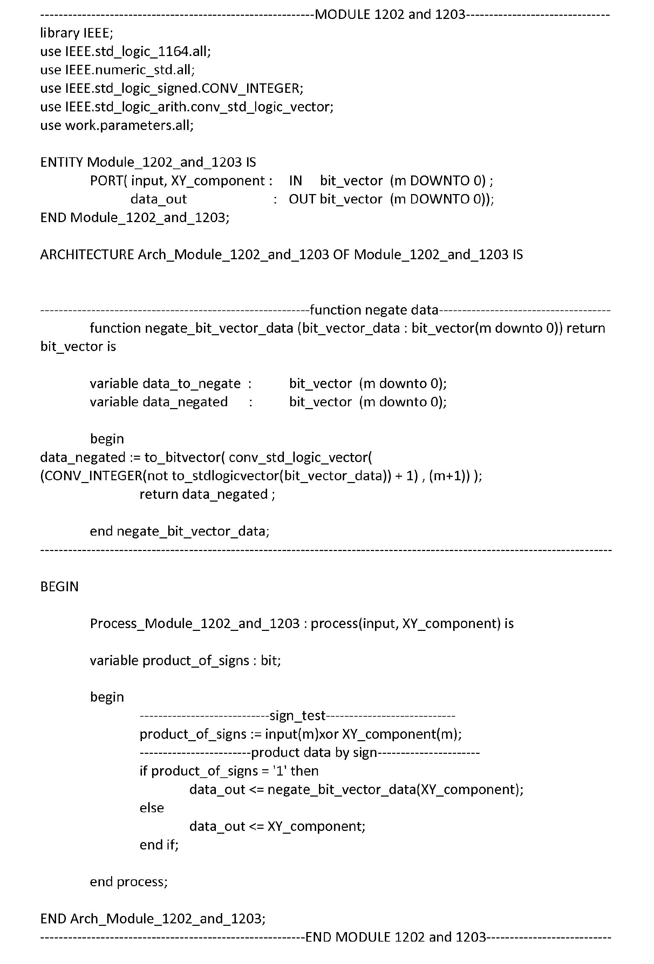

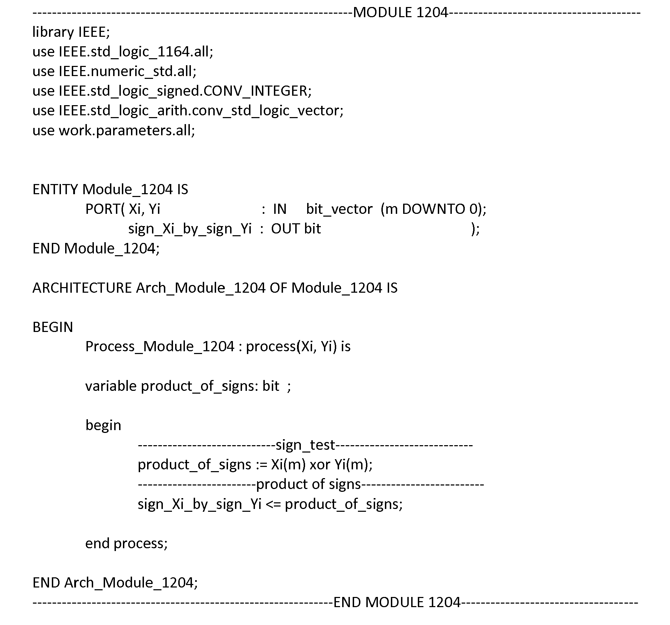

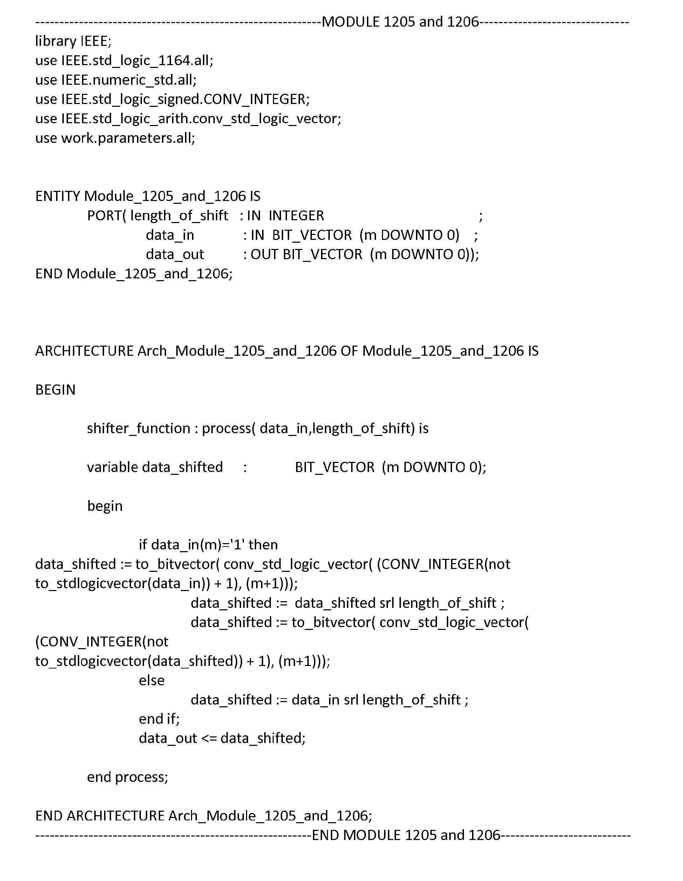

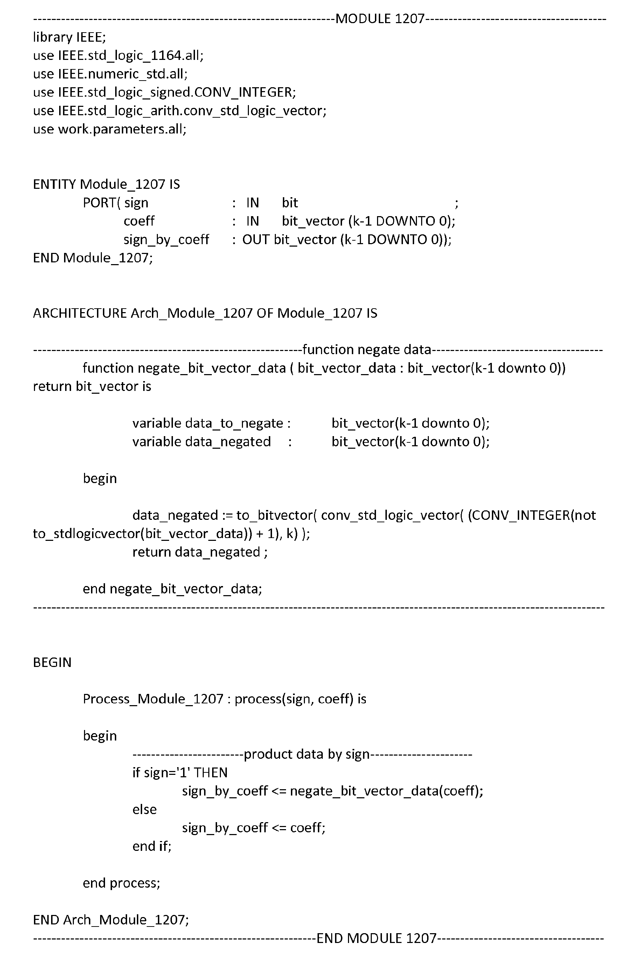

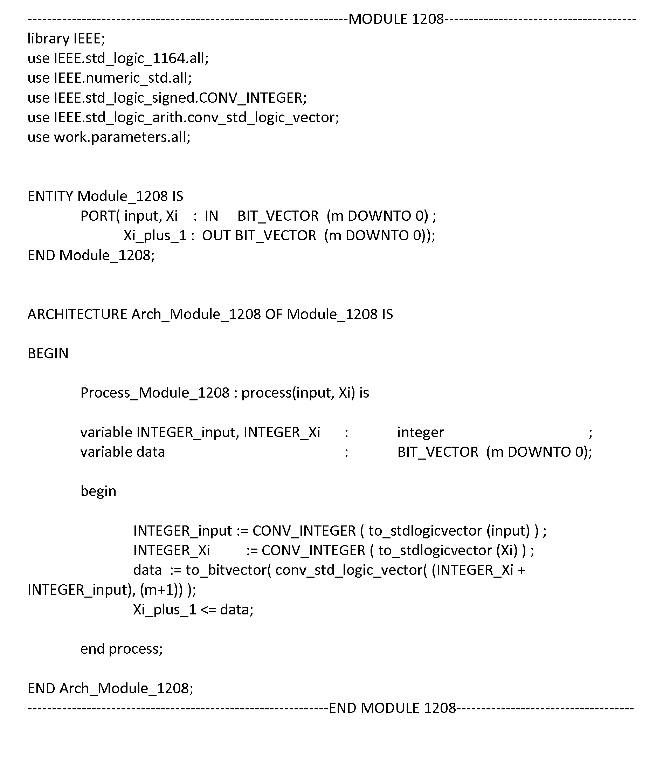

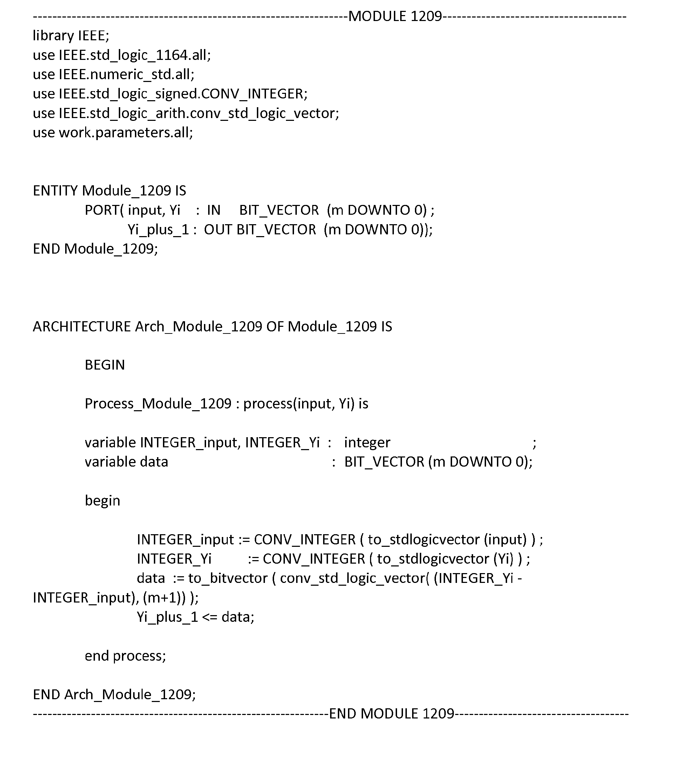

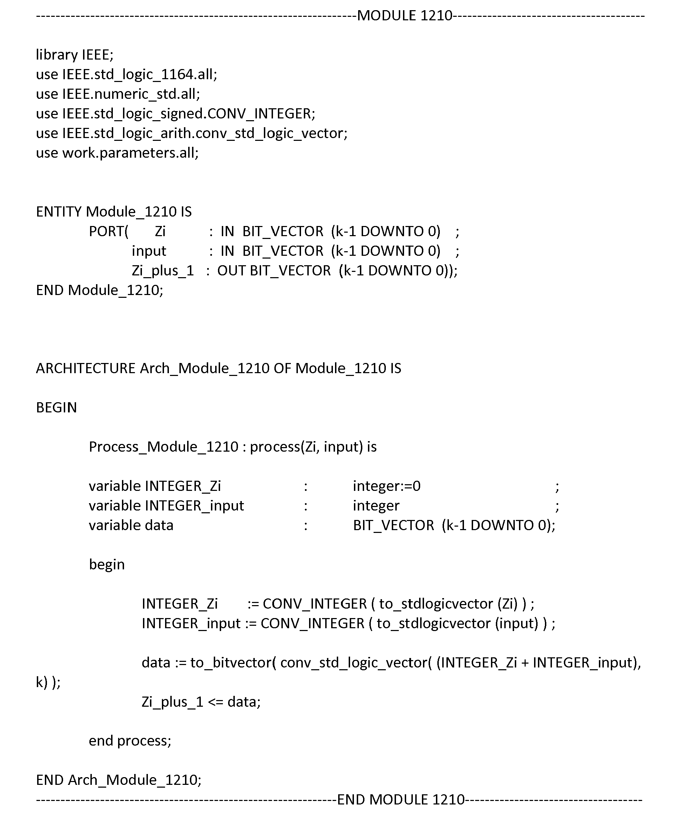

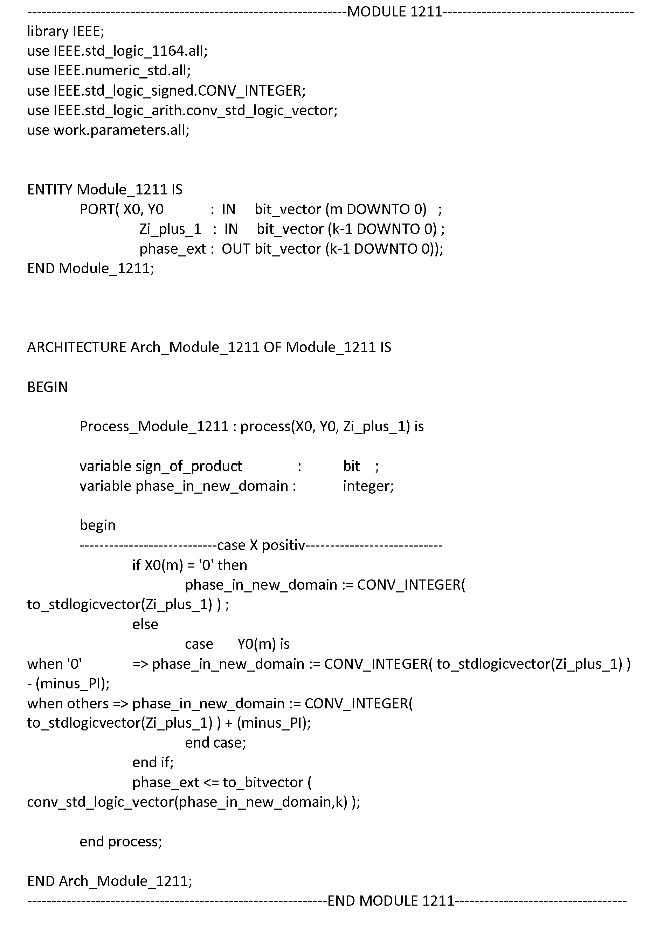

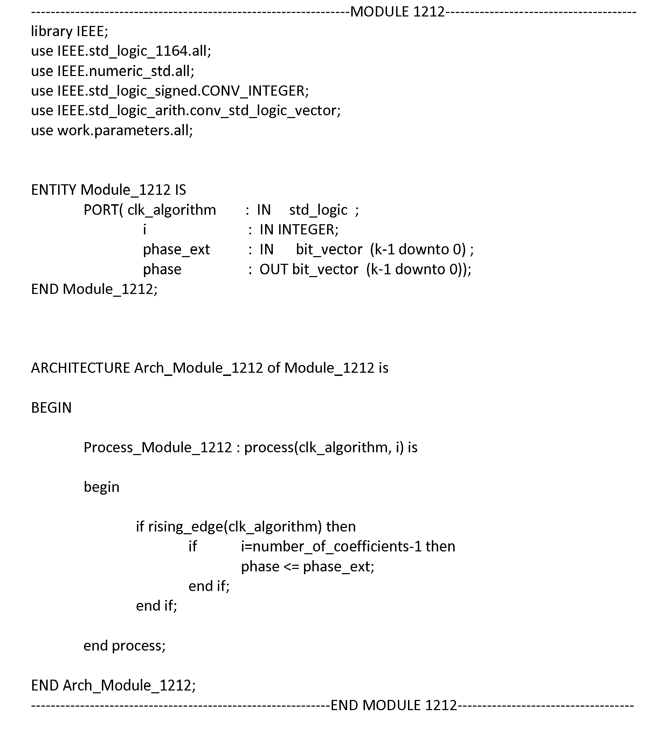

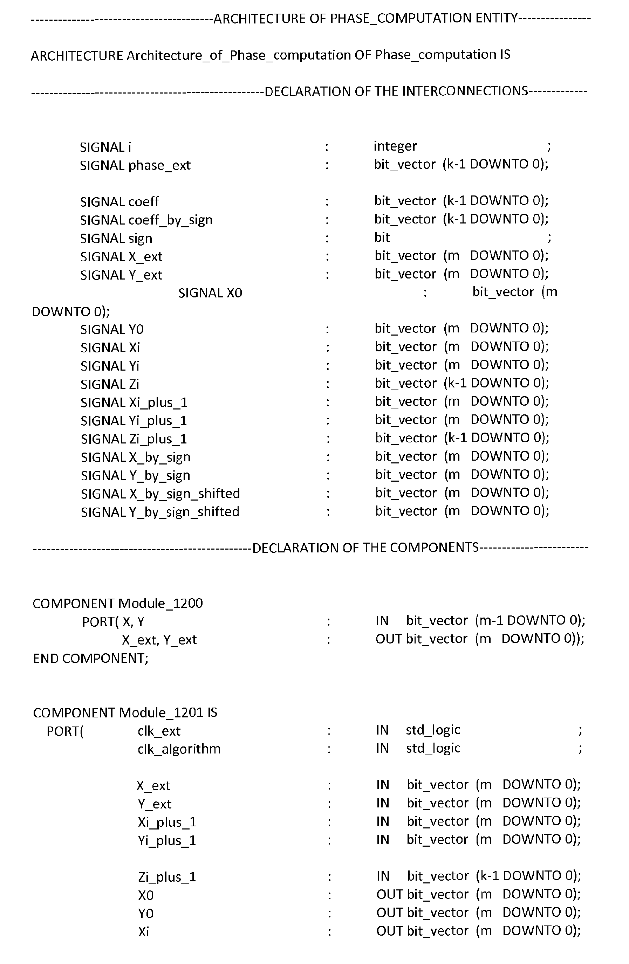

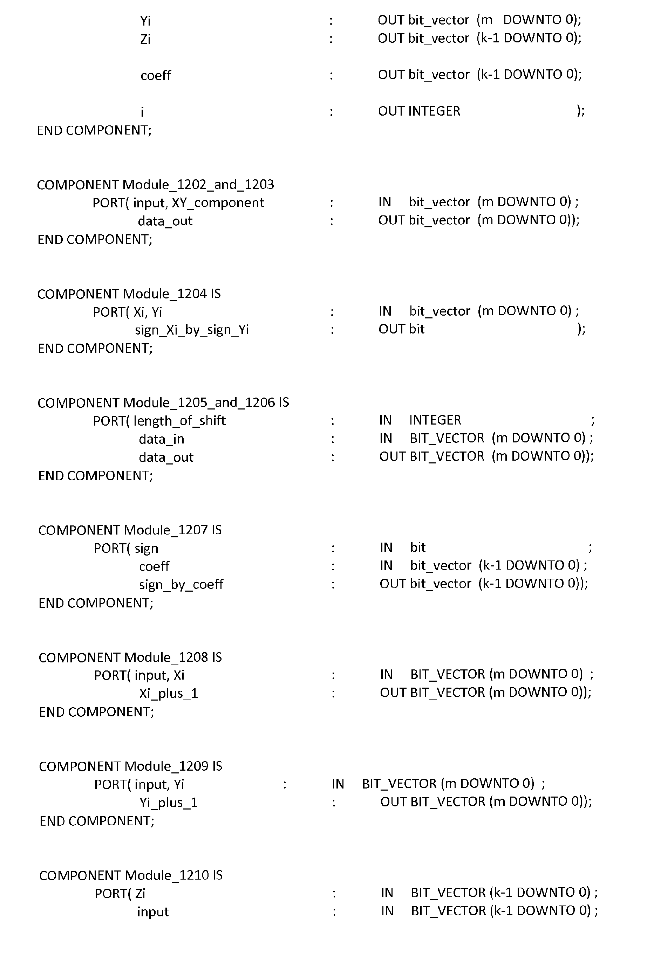

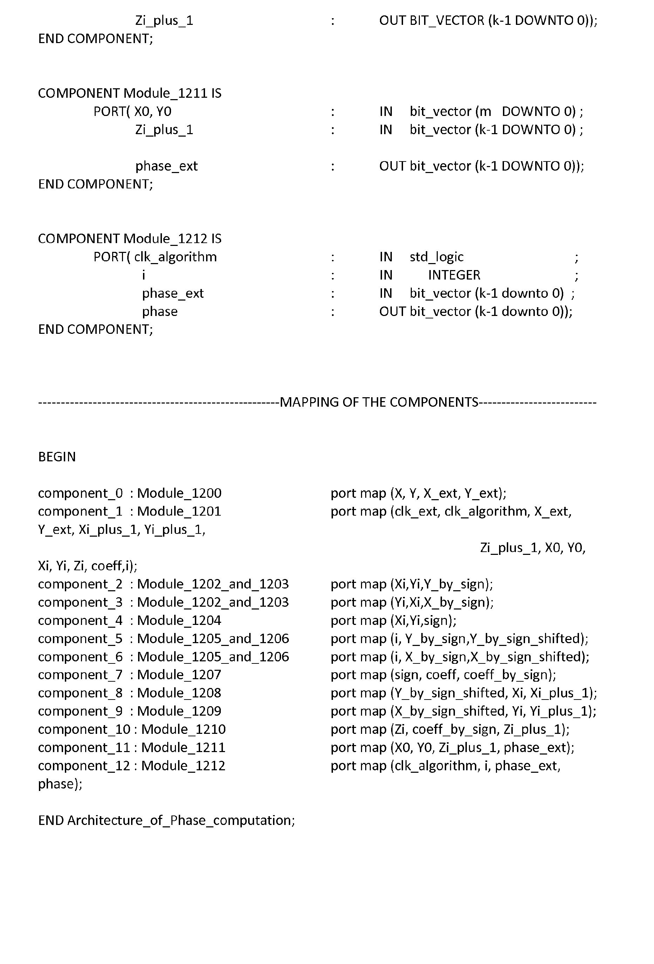

Fig. 13 describes the structure of Fig. 12 and the behavior of its modules with the VHDL language.

The clock event on *clk_algorithm* and *clk_ext* used for the computation and the synchronization is rising edge.

This code is the modified code of Fig. 6 for the structure of Fig. 12.

The modifications concern MODULE 401. The corresponding modified module is MODULE 1201.

Modification of the Phase_computation ENTITY:

A new input for *clk_ext* called clk_ext is added.

MODULE 1201

The synchronization consists in starting the phase computation on a defined event on the first cycle of clk_algorithm that follows a defined event on the first generated cycle of clk_ext. In the code both events on clk_algorithm and clk_ext are rising edge.

Fig.14 shows functional simulations of the code of Fig. 13.

Graph 14A of Fig. 14 parameters n=15, m=16 and k=19, number of cycles of clk_ext =1. The period of clk_ext is 15ns and for clk_algorithm 1 ns.

Graph 14B of Fig. 14 parameters n=15, m=16 and k=19, number of cycles of clk_ext =3. The period of clk_ext is 5ns and for clk_algorithm 1 ns.

Fig. 15 gives the general equations needed for the implementation and the simulation of the algorithm for data encoded with the signed integer representation.

1500 and 1501 determine the coefficients of the CORDIC algorithm equivalent to *atan*($2^{-i}$),

1502 gives the value of the angle of bit-length k equivalent to $-\pi$ rad.

1503 and 1504 give the value of the components X and Y of bit-length m in function of a given angle and are used for the simulations.

1505 resp. 1506 calibrates in degrees or radians the computed dimensionless phase. They are generally used for displaying the results of the computation on a computer.

1507 Gives the relation that must be mandatory satisfied between the clock clk_ext and clk_algorithm for a good working of the algorithm.

## References

[1] Jack E. Voider, The CORDIC Computing Technique, IRE Transactions on Electronic Computers, pp. 330-334, September 1959

[2] Ray Andraka, A survey of CORDIC algorihms for FPGA based computers

## Claims

1. Method for estimating a phase shift between an in-phase component and a quadrature component provided by a lock-in amplifier, comprising the steps of:

   - Providing an input signal (U),
   - Providing a first reference signal ($V_{ref}$),
   - Providing a second reference signal ($V_{ref,+90° \ phase \ shifted}$) that is phase shifted by +90° with respect to the first reference signal ($V_{ref}$),
   - Calculating said in-phase component (X) with the lock-in amplifier, which calculation comprises at least multiplying said first reference signal with the input signal and low-pass filtering the result to yield said in-phase component (*X*),
   - Calculating said quadrature component (*Y*) with the lock-in amplifier, which calculation comprises at least multiplying said second reference signal with the input signal and low-pass filtering the result to yield said quadrature component (*Y*),
   - Estimating the phase (*Z*) using the in-phase component and the quadrature component by means of a CORDIC algorithm.

2. Method according to claim 1, **characterized in that** the phase (*Z*) is estimated using the in-phase component (X) and the quadrature component (*Y*) by estimating one of: $\tan^{-1}\frac{Y}{X}$, $\sin^{-1}\frac{Y}{R}$, or $\cos^{-1}\frac{X}{R}$ by means of said CORDIC algorithm, wherein $R = \sqrt{X^2 + Y^2}$.

3. Method according to claim 1 or 2, **characterized in that** the phase (Z) is estimated using the in-phase component (*X*) and the quadrature component (Y) by means of said CORDIC algorithm which comprises calculating $x_n$, $y_n$ and $z_n$ iteratively using

$$x_{i+1} = x_i + \mathrm{sign}(x_i) \cdot \mathrm{sign}(y_i) \cdot y_i \cdot 2^{-i}$$

$$y_{i+1} = y_i - \text{sign}(x_i) \cdot \text{sign}(y_i) \cdot x_i \cdot 2^{-i}$$

$$z_{i+1} = z_i + \text{sign}(x_i) \cdot \text{sign}(y_i) \cdot \tan^{-1}(2^{-i})$$

wherein $i \in \{0, \dots, n - 1\}$, and wherein $x_0 = X$, $y_0 = Y$, $z_0 = 0$, and wherein the phase Z is estimated as $z_n$.

4. Method according to one of the preceding claims, **characterized in that** the CORDIC algorithms is conducted using an FPGA or an ASIC.

5. Method according to one of the preceding claims, **characterized in that** said phase shift ($\varphi(f)$), preferably a phase shift of an excited system, is evaluated by the lock-in amplifier in a phase locked-loop (PLL), which phase-locked loop comprises said lock-in amplifier, a PID controller (PID), and a numerically controlled oscillator (NCO), wherein the PID controller computes a frequency shift $\Delta\varphi$ PID from the difference $\Delta\varphi$ between a setpoint value $\varphi_{set}$ and said phase shift $\varphi(f)$, and wherein said numerically controlled oscillator(NCO) generates a signal having a frequency that is the sum of a reference frequency $f_{ref}$ and said frequency shift $\Delta\varphi_{PID}$.

6. System for estimating a phase shift between an in-phase component and a quadrature component provided by a lock-in amplifier, particularly for conducting the method according to one of the preceding claims, wherein the system comprises:

   - a lock-in amplifier which is configured to provide an in phase component and an quadrature component,
   - an arithmetic unit which is configured to receive said components and to estimate said phase (Z) using the in-phase component and the quadrature component by means of a CORDIC algorithm.

7. System according to claim 6, **characterized in that** said arithmetic unit comprises an FPGA or an ASIC for estimating said phase.

8. System according to claim 6 or 7, **characterized in that** said system further comprises at least one phase-locked loop (PLL), which phase-locked loop (PLL) comprises said lock-in amplifier, a PID controller, and a numerically controlled oscillator.

9. Computer program comprising software code which is adapted to conduct the following steps when executed on a computer or on a system according to one of the claims 6 to 8, or which is adapted to configure logic elements in an FPGA of a system according to one of the claims 6 to 8 to perform the following steps:

   Estimating the phase (Z) using the in-phase component and the quadrature component provided in before by a lock-in amplifier by means of a CORDIC algorithm.

Fig. 1

$$V_{ref} = A \cdot \sin(2 \cdot \pi \cdot f \cdot t + \emptyset_0)$$

$$U$$

$$V_{ref,+90° \, phase \, shifted} = A \cdot \cos(2 \cdot \pi \cdot f \cdot t + \emptyset_0)$$

CORDIC algorithm

Phase Z

Fig. 2

Fig. 2A

Fig. 2B

Fig. 3

```
┌──────────────────────────────────────┐
│  Computation of the phase with        │
│      the CORDIC algorithm             │
└──────────────────────────────────────┘
                    │
                    ▼
┌──────────────────────────────────────┐
│  Transposition of the phase in the    │
│    [±π[rad or [±180[ deg              │
│              domain                   │
└──────────────────────────────────────┘
                    │
                    ▼
┌──────────────────────────────────────┐
│  Display of the computed phase        │
│    after a number of cycles of        │
│  **clk_algorithm** equal to the       │
│     number of coefficients            │
└──────────────────────────────────────┘
```

Fig. 4

Fig. 5

(a)

(b)

Fig. 6

```
package parameters is
constant number_of_coefficients: integer;
constant m : integer;      -- bit-length of X and Y components
constant k : integer;       -- bit-length of phase
type     array_of_integers is array(14 downto 0) of integer;
constant coefficients            : array_of_integers;
constant coefficients_for_init : bit_vector;
constant bit_length_extension_positive : bit_vector;
constant bit_length_extension_negative : bit_vector;
constant minus_PI : integer;
end parameters;


package body parameters is
constant number_of_coefficients : integer:= 15;
constant m : integer := 16;
constant k : integer := 19;
constant coefficients  : array_of_integers :=
(5,10,20,41,81,163,326,652,1304,2607,5208,10377,20442,38688,65536);
constant coefficients_for_init  : bit_vector :=
('0','0','0','0','0','0','0','0','0','0','0','0','0','0','0','0','0','0','0');
constant bit_length_extension_positive  : bit_vector :=
('0','0','0','0','0','0','0','0','0','0','0','0','0','0','0','0','0');
constant bit_length_extension_negative : bit_vector  :=
('1','0','0','0','0','0','0','0','0','0','0','0','0','0','0','0','0');
constant minus_PI : integer := -262144;
end parameters;

library IEEE;
use IEEE.std_logic_1164.all;
use IEEE.std_logic_arith.conv_std_logic_vector;
use IEEE.numeric_std.all;
use IEEE.std_logic_signed.CONV_INTEGER;
use work.parameters.all;


-------------------------------------DECLARATION OF PHASE_COMPUTATION ENTITY------------------
ENTITY Phase_computation IS
        PORT( SIGNAL clk_algorithm    : IN  std_logic                    ;
              SIGNAL X                 : IN  bit_vector  (m-1 DOWNTO 0)  ;
              SIGNAL Y                 : IN  bit_vector  (m-1 DOWNTO 0)  ;
               SIGNAL phase            : OUT bit_vector  (k-1 DOWNTO 0));
END Phase_computation;
--------------------------------------------------------------------------------------------------------
```

```
--------------------------------------------------------MODULE 400---------------------------------------
library IEEE;
use IEEE.std_logic_1164.all;
use IEEE.std_logic_arith.conv_std_logic_vector;
use IEEE.numeric_std.all;
use IEEE.std_logic_signed.CONV_INTEGER;
use work.parameters.all;


ENTITY Module_400 IS
        PORT( X, Y                      : IN   bit_vector  (m-1 DOWNTO 0) ;
             X_ext, Y_ext               : OUT bit_vector  (m   DOWNTO 0));
END Module_400;



ARCHITECTURE Arch_Module_400 OF Module_400 IS

BEGIN

        process_Module_400 : process (X, Y) is

        variable X_pos: bit_vector(m DOWNTO 0) := bit_length_extension_positive;
        variable X_neg: bit_vector(m DOWNTO 0) := bit_length_extension_negative;
        variable Y_pos: bit_vector(m DOWNTO 0) := bit_length_extension_positive;
        variable Y_neg: bit_vector(m DOWNTO 0) := bit_length_extension_negative;
        begin

                if   X(m-1)='0' and Y(m-1)='0' then
                        X_pos(m-1 DOWNTO 0):= X;
                        X_ext <= X_pos;
                        Y_pos(m-1 DOWNTO 0):= Y;
                        Y_ext  <= Y_pos;
                elsif X(m-1)='0' and Y(m-1)='1' then
                        X_pos(m-1 DOWNTO 0):= X;
                        X_ext  <= X_pos;
                        Y_neg(m-1 DOWNTO 0):= Y;
                        Y_ext  <= Y_neg;
                elsif X(m-1)='1' and Y(m-1)='0' then
                        X_neg(m-1 DOWNTO 0):= X;
                        X_ext  <= X_neg;
                        Y_pos(m-1 DOWNTO 0):= Y;
                        Y_ext  <= Y_pos;
                else X_neg(m-1 DOWNTO 0):= X;
                        X_ext   <= X_neg;
                        Y_neg(m-1 DOWNTO 0):= Y;
                        Y_ext   <= Y_neg;

                end if;
        end process;
```

```
END ARCHITECTURE Arch_Module_400;
---------------------------------------------------------END MODULE 400-----------------------------------
-----------------------------------------------------------MODULE 401-------------------------------------
library IEEE;
use IEEE.std_logic_1164.all;
use IEEE.numeric_std.all;
use IEEE.std_logic_signed.CONV_INTEGER;
use IEEE.std_logic_arith.conv_std_logic_vector;
use work.parameters.all;

ENTITY Module_401 IS
        PORT( clk_algorithm     : IN    std_logic                    ;
              X_ext             : IN    bit_vector  (m DOWNTO 0) ;
              Y_ext             : IN    bit_vector  (m DOWNTO 0) ;
              Xi_plus_1         : IN    bit_vector  (m DOWNTO 0) ;
              Yi_plus_1         : IN    bit_vector  (m DOWNTO 0) ;
              Zi_plus_1         : IN    bit_vector  (k-1 DOWNTO 0);
              X0                : OUT bit_vector  (m DOWNTO 0) ;
              Y0                : OUT bit_vector  (m DOWNTO 0) ;
              Xi                : OUT bit_vector  (m DOWNTO 0) ;
              Yi                : OUT bit_vector  (m DOWNTO 0) ;
              Zi                : OUT bit_vector  (k-1 DOWNTO 0);
              coeff             : OUT bit_vector  (k-1 DOWNTO 0);
              i                 : OUT integer                );
END Module_401;

ARCHITECTURE Arch_Module_401 OF Module_401 IS

BEGIN
        process_Module_401 : process (clk_algorithm, X_ext, Y_ext, Xi_plus_1, Yi_plus_1,
Zi_plus_1) is

                constant number_of_coefficients :      integer:= number_of_coefficients;
                variable j                      :      integer:=0;
                variable table_of_coefficients  :      array_of_integers := coefficients;

            begin
                if rising_edge(clk_algorithm) then

                    case j is
                    when 0  =>      Xi <= X_ext;
                                                Yi <= Y_ext;
                                    Zi<= coefficients_for_init;
                                    coeff <= to_bitvector(
conv_std_logic_vector(table_of_coefficients(0),k) );
                                        i<= j;
                                        X0<= X_ext;
                                        Y0<= Y_ext;

                    when others =>  Xi<= Xi_plus_1;
                                    Yi<= Yi_plus_1;
```

```
                              Zi<= Zi_plus_1 ;
                              coeff <= to_bitvector(
conv_std_logic_vector(table_of_coefficients(j),k) );
                              i<= j;


              end case;
              j := j+1;
              if j=number_of_coefficients then
                      j := 0;
              end if;
        end if;
     end process;
END Arch_Module_401;
```
--------------------------------------------------------END MODULE 401-----------------------------------


-----------------------------------------------------MODULE 402 and 403--------------------------------

```
library IEEE;
use IEEE.std_logic_1164.all;
use IEEE.numeric_std.all;
use IEEE.std_logic_signed.CONV_INTEGER;
use IEEE.std_logic_arith.conv_std_logic_vector;
use work.parameters.all;


ENTITY Module_402_and_403 IS
        PORT( input, XY_component :   IN    bit_vector  (m DOWNTO 0) ;
              data_out                 : OUT bit_vector  (m DOWNTO 0));
END Module_402_and_403;


ARCHITECTURE Arch_Module_402_and_403 OF Module_402_and_403 IS
```


----------------------------------------------------function negate data------------------------------------
```
      function negate_bit_vector_data (bit_vector_data : bit_vector(m downto 0)) return
bit_vector is

        variable data_to_negate  :      bit_vector  (m downto 0);
        variable data_negated    :      bit_vector  (m downto 0);


        begin
data_negated := to_bitvector( conv_std_logic_vector(
(CONV_INTEGER(not to_stdlogicvector(bit_vector_data)) + 1) , (m+1)) );
              return data_negated ;

        end negate_bit_vector_data;
```
------------------------------------------------------------------------------------------------------------


```
BEGIN

        Process_Module_402_and_403 : process(input, XY_component) is
```

```
                variable product_of_signs : bit;

                begin
                        --------------------------sign_test--------------------------
                        product_of_signs := input(m)xor XY_component(m);
                        ----------------------product data by sign--------------------
                        if product_of_signs = '1' then
                                data_out <= negate_bit_vector_data(XY_component);
                        else
                                data_out <= XY_component;
                        end if;

                end process;

END Arch_Module_402_and_403;
--------------------------------------------------------END MODULE 402 and 403----------------------------



--------------------------------------------------------------MODULE 404----------------------------------------
library IEEE;
use IEEE.std_logic_1164.all;
use IEEE.numeric_std.all;
use IEEE.std_logic_signed.CONV_INTEGER;
use IEEE.std_logic_arith.conv_std_logic_vector;
use work.parameters.all;


ENTITY Module_404 IS
        PORT( Xi, Yi                    : IN    bit_vector  (m DOWNTO 0);
                sign_Xi_by_sign_Yi  : OUT bit                        );
END Module_404;

ARCHITECTURE Arch_Module_404 OF Module_404 IS

BEGIN
        Process_Module_404 : process(Xi, Yi) is

        variable product_of_signs: bit  ;

        begin
                --------------------------sign_test--------------------------
                product_of_signs := Xi(m) xor Yi(m);
                ----------------------product of signs----------------------
                sign_Xi_by_sign_Yi <= product_of_signs;

        end process;

END Arch_Module_404;
--------------------------------------------------------END MODULE 404----------------------------------------
```

```
-------------------------------------------------------MODULE 405 and 406---------------------------------
library IEEE;
use IEEE.std_logic_1164.all;
use IEEE.numeric_std.all;
use IEEE.std_logic_signed.CONV_INTEGER;
use IEEE.std_logic_arith.conv_std_logic_vector;
use work.parameters.all;


ENTITY Module_405_and_406 IS
        PORT( length_of_shift  : IN  INTEGER                     ;
                   data_in         : IN  BIT_VECTOR  (m DOWNTO 0)   ;
                   data_out        : OUT BIT_VECTOR  (m DOWNTO 0));
END Module_405_and_406;



ARCHITECTURE Arch_Module_405_and_406 OF Module_405_and_406 IS

BEGIN

        shifter_function : process( data_in,length_of_shift) is

        variable data_shifted    :          BIT_VECTOR  (m DOWNTO 0);

        begin

                if data_in(m)='1' then
data_shifted := to_bitvector( conv_std_logic_vector( (CONV_INTEGER(not
to_stdlogicvector(data_in)) + 1), (m+1)));
                        data_shifted :=  data_shifted srl length_of_shift ;
                        data_shifted := to_bitvector( conv_std_logic_vector(
(CONV_INTEGER(not
to_stdlogicvector(data_shifted)) + 1), (m+1)));
                else
                        data_shifted := data_in srl length_of_shift ;
                end if;
                data_out <= data_shifted;

        end process;

END ARCHITECTURE Arch_Module_405_and_406;
-------------------------------------------------------END MODULE 405 and 406----------------------------
```

```
----------------------------------------------------------MODULE 407--------------------------------------
library IEEE;
use IEEE.std_logic_1164.all;
use IEEE.numeric_std.all;
use IEEE.std_logic_signed.CONV_INTEGER;
use IEEE.std_logic_arith.conv_std_logic_vector;
use work.parameters.all;


ENTITY Module_407 IS
        PORT( sign            : IN    bit                        ;
              coeff           : IN    bit_vector (k-1 DOWNTO 0);
              sign_by_coeff   : OUT bit_vector (k-1 DOWNTO 0));
END Module_407;


ARCHITECTURE Arch_Module_407 OF Module_407 IS

----------------------------------------------------function negate data------------------------------------
        function negate_bit_vector_data ( bit_vector_data : bit_vector(k-1 downto 0))
return bit_vector is

                variable data_to_negate :      bit_vector(k-1 downto 0);
                variable data_negated   :      bit_vector(k-1 downto 0);


        begin

                data_negated := to_bitvector( conv_std_logic_vector( (CONV_INTEGER(not
to_stdlogicvector(bit_vector_data)) + 1), k) );
                return data_negated ;

        end negate_bit_vector_data;
-----------------------------------------------------------------------------------------------------------

BEGIN

        Process_Module_407 : process(sign, coeff) is

        begin
                ----------------------product data by sign----------------------
                if sign='1' THEN
                        sign_by_coeff <= negate_bit_vector_data(coeff);
                else
                        sign_by_coeff <= coeff;
                end if;

        end process;

END Arch_Module_407;
-----------------------------------------------------END MODULE 407--------------------------------------
```

```
-------------------------------------------------------------MODULE 408----------------------------------------
library IEEE;
use IEEE.std_logic_1164.all;
use IEEE.numeric_std.all;
use IEEE.std_logic_signed.CONV_INTEGER;
use IEEE.std_logic_arith.conv_std_logic_vector;
use work.parameters.all;


ENTITY Module_408 IS
        PORT( input, Xi   : IN    BIT_VECTOR  (m DOWNTO 0) ;
                Xi_plus_1 :  OUT BIT_VECTOR  (m DOWNTO 0));
END Module_408;


ARCHITECTURE Arch_Module_408 OF Module_408 IS

BEGIN

        Process_Module_408 : process(input, Xi) is

        variable INTEGER_input, INTEGER_Xi    :        integer                          ;
        variable data                         :        BIT_VECTOR  (m DOWNTO 0);

        begin

                INTEGER_input := CONV_INTEGER ( to_stdlogicvector (input) ) ;
                INTEGER_Xi       := CONV_INTEGER ( to_stdlogicvector (Xi) ) ;
                data  := to_bitvector( conv_std_logic_vector( (INTEGER_Xi +
INTEGER_input), (m+1)) );
                Xi_plus_1 <= data;

        end process;

END Arch_Module_408;
-----------------------------------------------------------END MODULE 408------------------------------------
```

```
--------------------------------------------------------------MODULE 409---------------------------------------
library IEEE;
use IEEE.std_logic_1164.all;
use IEEE.numeric_std.all;
use IEEE.std_logic_signed.CONV_INTEGER;
use IEEE.std_logic_arith.conv_std_logic_vector;
use work.parameters.all;


ENTITY Module_409 IS
        PORT( input, Yi   : IN    BIT_VECTOR  (m DOWNTO 0) ;
                Yi_plus_1 : OUT BIT_VECTOR  (m DOWNTO 0));
END Module_409;



ARCHITECTURE Arch_Module_409 OF Module_409 IS

        BEGIN

        Process_Module_409 : process(input, Yi) is

        variable INTEGER_input, INTEGER_Yi :   integer                        ;
        variable data                      :  BIT_VECTOR (m DOWNTO 0);

        begin

                INTEGER_input := CONV_INTEGER ( to_stdlogicvector (input) ) ;
                INTEGER_Yi       := CONV_INTEGER ( to_stdlogicvector (Yi) ) ;
                data  := to_bitvector ( conv_std_logic_vector( (INTEGER_Yi -
INTEGER_input), (m+1)) );
                Yi_plus_1 <= data;

        end process;

END Arch_Module_409;
---------------------------------------------------------END MODULE 409------------------------------------
```

----------------------------------------------------------MODULE 410--------------------------------------

```
library IEEE;
use IEEE.std_logic_1164.all;
use IEEE.numeric_std.all;
use IEEE.std_logic_signed.CONV_INTEGER;
use IEEE.std_logic_arith.conv_std_logic_vector;
use work.parameters.all;


ENTITY Module_410 IS
        PORT(
                Zi          : IN  BIT_VECTOR  (k-1 DOWNTO 0)   ;
                input       : IN  BIT_VECTOR  (k-1 DOWNTO 0)   ;
                Zi_plus_1  : OUT BIT_VECTOR  (k-1 DOWNTO 0));
END Module_410;



ARCHITECTURE Arch_Module_410 OF Module_410 IS

BEGIN

        Process_Module_410 : process(Zi, input) is

        variable INTEGER_Zi             :        integer:=0                        ;
        variable INTEGER_coefficient    :        integer                           ;
        variable data                   :        BIT_VECTOR  (k-1 DOWNTO 0);

        begin

                INTEGER_Zi           := CONV_INTEGER ( to_stdlogicvector (Zi) ) ;
                INTEGER_coefficient := CONV_INTEGER ( to_stdlogicvector (input) ) ;

                data := to_bitvector( conv_std_logic_vector( (INTEGER_Zi +
INTEGER_coefficient), k) );
                Zi_plus_1 <= data;

        end process;

END Arch_Module_410;
```

----------------------------------------------------------END MODULE 410------------------------------------

```
-----------------------------------------------------MODULE 411-------------------------------------
library IEEE;
use IEEE.std_logic_1164.all;
use IEEE.numeric_std.all;
use IEEE.std_logic_signed.CONV_INTEGER;
use IEEE.std_logic_arith.conv_std_logic_vector;
use work.parameters.all;


ENTITY Module_411 IS
        PORT( X0, Y0         : IN    bit_vector (m DOWNTO 0)  ;
                  Zi_plus_1  : IN    bit_vector (k-1 DOWNTO 0) ;
                  phase_ext  : OUT bit_vector (k-1 DOWNTO 0));
END Module_411;



ARCHITECTURE Arch_Module_411 OF Module_411 IS

BEGIN

        Process_Module_411 : process(X0, Y0, Zi_plus_1) is

        variable sign_of_product        :       bit   ;
        variable phase_in_new_domain :          integer;

        begin
-----------------------------case X positiv---------------------------
                if X0(m) = '0' then
                        phase_in_new_domain := CONV_INTEGER(
to_stdlogicvector(Zi_plus_1) ) ;
                else
                        case      Y0(m) is
                        when '0'        => phase_in_new_domain := CONV_INTEGER(
                                to_stdlogicvector(Zi_plus_1) )
                                                                                -
                                                                        (minus_PI);

                        when others => phase_in_new_domain := CONV_INTEGER(
                                                                to_stdlogicvector(Zi_
                                                                plus_1) ) +
                                                                (minus_PI);

                        end case;
                end if;
                phase_ext <= to_bitvector (
conv_std_logic_vector(phase_in_new_domain,k) );

        end process;

END Arch_Module_411;
```

```
-------------------------------------------------------END MODULE 411------------------------------------
-------------------------------------------------------MODULE 412------------------------------------------
library IEEE;
use IEEE.std_logic_1164.all;
use IEEE.numeric_std.all;
use IEEE.std_logic_signed.CONV_INTEGER;
use IEEE.std_logic_arith.conv_std_logic_vector;
use work.parameters.all;


ENTITY Module_412 IS
        PORT( clk_algorithm    : IN   std_logic ;
                i              : IN INTEGER;
                phase_ext      : IN   bit_vector  (k-1 downto 0) ;
                phase          : OUT bit_vector  (k-1 downto 0));
END Module_412;



ARCHITECTURE Arch_Module_412 of Module_412 is

BEGIN

        Process_Module_412 : process(clk_algorithm, i) is

        begin

                if rising_edge(clk_algorithm) then
                        if      i=number_of_coefficients-1 then
                                phase <= phase_ext;
                        end if;
                end if;

        end process;

END Arch_Module_412;
-------------------------------------------------------END MODULE 412------------------------------------
```

```
-------------------------------------ARCHITECTURE OF PHASE_COMPUTATION ENTITY--------------

ARCHITECTURE Architecture_of_Phase_computation OF Phase_computation IS

-----------------------------------------------DECLARATION OF THE INTERCONNECTIONS-------------


        SIGNAL i                        :       integer                      ;
        SIGNAL phase_ext                :       bit_vector (k-1 DOWNTO 0);

        SIGNAL coeff                    :       bit_vector (k-1 DOWNTO 0);
        SIGNAL coeff_by_sign            :       bit_vector (k-1 DOWNTO 0);
        SIGNAL sign                     :       bit                          ;
        SIGNAL X_ext                    :       bit_vector (m  DOWNTO 0);
        SIGNAL Y_ext                    :       bit_vector (m  DOWNTO 0);

        SIGNAL X0                       :       bit_vector (m  DOWNTO 0);
        SIGNAL Y0                       :       bit_vector (m  DOWNTO 0);
        SIGNAL Xi                       :       bit_vector (m  DOWNTO 0);
        SIGNAL Yi                       :       bit_vector (m  DOWNTO 0);
        SIGNAL Zi                       :       bit_vector (k-1 DOWNTO 0);
        SIGNAL Xi_plus_1                :       bit_vector (m  DOWNTO 0);
        SIGNAL Yi_plus_1                :       bit_vector (m  DOWNTO 0);
        SIGNAL Zi_plus_1                :       bit_vector (k-1 DOWNTO 0);
        SIGNAL X_by_sign                :       bit_vector (m  DOWNTO 0);
        SIGNAL Y_by_sign                :       bit_vector (m  DOWNTO 0);
        SIGNAL X_by_sign_shifted        :       bit_vector (m  DOWNTO 0);
        SIGNAL Y_by_sign_shifted        :       bit_vector (m  DOWNTO 0);

----------------------------------------------DECLARATION OF THE COMPONENTS------------------------


COMPONENT Module_400
        PORT( X, Y                      :       IN   bit_vector (m-1 DOWNTO 0);
                X_ext, Y_ext            :       OUT bit_vector (m  DOWNTO 0));
END COMPONENT;


COMPONENT Module_401 IS
        PORT( clk_algorithm             :       IN   std_logic                   ;
                X_ext                   :       IN   bit_vector (m  DOWNTO 0);
                Y_ext                   :       IN   bit_vector (m  DOWNTO 0);
                Xi_plus_1               :       IN   bit_vector (m  DOWNTO 0);
                Yi_plus_1               :       IN   bit_vector (m  DOWNTO 0);

                Zi_plus_1               :       IN   bit_vector (k-1 DOWNTO 0);
                X0                      :       OUT bit_vector (m  DOWNTO 0);
                Y0                      :       OUT bit_vector (m  DOWNTO 0);
                Xi                      :       OUT bit_vector (m  DOWNTO 0);
                Yi                      :       OUT bit_vector (m  DOWNTO 0);
```

```
            Zi                           :        OUT bit_vector (k-1 DOWNTO 0);
            coeff                        :        OUT bit_vector (k-1 DOWNTO 0);
            i                            :        OUT INTEGER                    );
END COMPONENT;




COMPONENT Module_402_and_403
      PORT( input, XY_component         :        IN    bit_vector (m DOWNTO 0) ;
            data_out                    :        OUT bit_vector (m DOWNTO 0));
END COMPONENT;



COMPONENT Module_404 IS
      PORT( Xi, Yi                      :        IN    bit_vector (m DOWNTO 0) ;
            sign_Xi_by_sign_Yi          :        OUT bit                        );
END COMPONENT;



COMPONENT Module_405_and_406 IS
      PORT( length_of_shift             :        IN    INTEGER                   ;
            data_in                     :        IN    BIT_VECTOR (m DOWNTO 0) ;
            data_out                    :        OUT BIT_VECTOR (m DOWNTO 0));
END COMPONENT;



COMPONENT Module_407 IS
      PORT( sign                        :        IN    bit                       ;
            coeff                       :        IN    bit_vector (k-1 DOWNTO 0) ;
            sign_by_coeff               :        OUT bit_vector (k-1 DOWNTO 0));
END COMPONENT;



COMPONENT Module_408 IS
      PORT( input, Xi                   :        IN    BIT_VECTOR (m DOWNTO 0) ;
            Xi_plus_1                   :        OUT BIT_VECTOR (m DOWNTO 0));
END COMPONENT;



COMPONENT Module_409 IS
      PORT( input, Yi            :       IN    BIT_VECTOR (m DOWNTO 0) ;
            Yi_plus_1                   :        OUT BIT_VECTOR (m DOWNTO 0));
END COMPONENT;



COMPONENT Module_410 IS
      PORT( Zi                          :        IN    BIT_VECTOR (k-1 DOWNTO 0) ;
            input                       :        IN    BIT_VECTOR (k-1 DOWNTO 0) ;
```

```
            Zi_plus_1                    :        OUT BIT_VECTOR (k-1 DOWNTO 0));
END COMPONENT;



COMPONENT Module_411 IS
    PORT( X0, Y0                         :        IN    bit_vector (m   DOWNTO 0) ;
            Zi_plus_1                    :        IN    bit_vector (k-1 DOWNTO 0) ;


            phase_ext                    :        OUT bit_vector (k-1 DOWNTO 0));
END COMPONENT;




COMPONENT Module_412 IS
    PORT( clk_algorithm                  :        IN    std_logic            ;
            i                            :        IN    INTEGER              ;
            phase_ext                    :        IN    bit_vector (k-1 downto 0) ;
            phase                        :        OUT bit_vector (k-1 downto 0));
END COMPONENT;
```

---------------------------------------------------MAPPING OF THE COMPONENTS------------------------

BEGIN

```
component_0  : Module_400              port map (X, Y, X_ext, Y_ext);
component_1  : Module_401              port map (clk_algorithm, X_ext, Y_ext,
Xi_plus_1, Yi_plus_1,

                                                         Zi_plus_1, X0, Y0,
Xi, Yi, Zi, coeff,i);
component_2  : Module_402_and_403      port map (Xi,Yi,Y_by_sign);
component_3  : Module_402_and_403      port map (Yi,Xi,X_by_sign);
component_4  : Module_404              port map (Xi,Yi,sign);
component_5  : Module_405_and_406      port map (i, Y_by_sign,Y_by_sign_shifted);
component_6  : Module_405_and_406      port map (i, X_by_sign,X_by_sign_shifted);
component_7  : Module_407              port map (sign, coeff, coeff_by_sign);
component_8  : Module_408              port map (Y_by_sign_shifted, Xi, Xi_plus_1);
component_9  : Module_409              port map (X_by_sign_shifted, Yi, Yi_plus_1);
component_10 : Module_410              port map (Zi, coeff_by_sign, Zi_plus_1);
component_11 : Module_411              port map (X0, Y0, Zi_plus_1, phase_ext);
component_12 : Module_412              port map (clk_algorithm, i, phase_ext,
phase);
```

END Architecture_of_Phase_computation;

Fig. 7

Fig. 8

| X | Y | phase from CORDIC | phase from CORDIC in deg | arctan2 in deg |
|---|---|---|---|---|
| -32767 | 0 | -262144 | -179,9999998 | 180 |
| -32767 | 6 | 262134 | 179,9931333 | 179,99 |
| -32767 | 57 | 262002 | 179,9024961 | 179,9 |
| -32747 | 1144 | 259232 | 178,0004881 | 178 |
| -32269 | 5690 | 247580 | 169,9996946 | 170 |
| -30982 | 10668 | 234478 | 161,0032652 | 161 |
| -28675 | 15856 | 219998 | 151,0606382 | 151,06 |
| -25821 | 20173 | 206798 | 141,9969176 | 142 |
| -21497 | 24730 | 190786 | 131,0023497 | 131 |
| -15886 | 28659 | 173300 | 118,9956664 | 119 |
| -11486 | 30688 | 160950 | 110,5155944 | 110,52 |
| -6814 | 32051 | 148546 | 101,9984435 | 102,003 |
| -572 | 32763 | 132526 | 90,99838246 | 91 |
| 0 | 32767 | 131082 | 90,00686635 | 90 |
| 2673 | 32658 | 124268 | 85,32806386 | 85,32 |
| 9361 | 31401 | 106898 | 73,40103141 | 73,4 |
| 16135 | 28519 | 88112 | 60,50170891 | 60,5 |
| 21049 | 25112 | 72868 | 50,0344848 | 50,03 |
| 23170 | 23170 | 65534 | 44,99862666 | 45 |
| 27481 | 17846 | 48054 | 32,99606319 | 33 |
| 29934 | 13328 | 34958 | 24,00375363 | 24 |
| 32269 | 5690 | 14564 | 10,00030516 | 10 |
| 32631 | 2987 | 7618 | 5,230865472 | 5,23 |
| 32762 | 572 | 1454 | 0,998382567 | 1 |
| 32767 | 0 | 0 | 0 | 0 |
| 32747 | -1144 | -2912 | -1,999511716 | -2 |
| 31650 | -8481 | -21844 | -14,99908445 | -15 |
| 30162 | -12803 | -33492 | -22,99713132 | -23 |
| 28377 | -16383 | -43694 | -30,00228878 | -30 |
| 24331 | -21947 | -61240 | -42,05017085 | -42,05 |
| 18375 | -27130 | -81388 | -55,88470452 | -55,89 |
| 14866 | -29201 | -91776 | -63,01757805 | -63,02 |
| 10668 | -30982 | -103406 | -71,0032653 | -71 |
| 57 | -32767 | -130930 | -89,90249623 | -89,9 |
| 0 | -32767 | -131072 | -89,99999989 | -90 |
| -6 | -32767 | -131082 | -90,00686635 | -90,01 |
| -6252 | -32165 | -147092 | -101,0000609 | -101 |
| -13848 | -29697 | -167488 | -115,0048827 | -115 |
| -17856 | -27474 | -179166 | -123,0235289 | -123,02 |
| -23007 | -23331 | -196030 | -134,6031187 | -134,6 |
| -26165 | -19724 | -208244 | -142,989807 | -142,99 |
| -28681 | -15845 | -220028 | -151,0812376 | -151,081 |
| -32075 | -6701 | -244966 | -168,2048033 | -168,2 |
| -32523 | -3993 | -251948 | -172,9989622 | -173 |
| -32645 | -2822 | -254954 | -175,0630186 | -175,06 |
| -32732 | -1515 | -258294 | -177,3564146 | -177,35 |
| -32747 | -1141 | -259242 | -178,0073545 | -178,005 |
| -32767 | -6 | -262134 | -179,9931333 | -179,99 |
| -32767 | 0 | -262144 | -179,9999998 | -180 |

Fig. 9

Fig. 10

1000

clock cycle of *clk_ext*

clock cycle of *clk_algorithm*

1001

n cycles of *clk_algorithm*

1002

clock cycle of *clk_ext*

clock cycle of *clk_algorithm*

1003

n cycles of *clk_algorithm*

EP 3 121 709 A1

Fig. 11

Fig. 11A

Fig. 11B

Fig. 12

40

1200

$X$ [m-1..0] → X  X_ext → X_ext [m..0]
$Y$ [m-1..0] → Y  Y_ext → Y_ext [m..0]

(a)

1201

X_ext [m..0] → X_ext
Y_ext [m..0] → Y_ext
→ Xi+1
→ Yi+1
→ Zi+1

clk_ext
clk_algorithm

X0
Y0
i
Xi
Yi
Zi
coeff

clk_ext
clk_algorithm

1202

Xi
Yi
sign(Xi)· sign(Yi) ·Yi → sign(Xi)· sign(Yi) · Yi [m..0]

1205

i
input   input· 2^{-i} → sign(Xi)· sign(Yi) · Yi· 2^{-i} [m..0]

Xi [m..0]

1208

input
Xi   Xi+input

1203

Xi
Yi
sign(Xi)· sign(Yi) · Xi → sign(Xi)· sign(Yi) · Xi [m..0]

1206

i
input   input· 2^{-i} → sign(Xi)· sign(Yi) · Xi· 2^{-i} [m..0]

Yi [m..0]

1209

input
Yi   Yi-input

1204

Xi
Yi
sign(Xi)· sign(Yi) → sign(Xi)· sign(Yi)

1207

sign
coeff   sign_by_coeff

atan(2^-i) [k-1..0] → 

sign(Xi)· sign(Yi) · atan(2^-i) [k-1..0]

Zi [k-1..0]

1210

Zi
Input   Zi+input

X0 [m..0]
Y0 [m..0]
Zi+1 [k-1..0]

i

Zi+1 [k-1..0]
Yi+1 [m..0]
Xi+1 [m..0]

(b)

1212

clk_algorithm → clk_algorithm
i → i   phase → phase [k-1..0]
phase_ext → phase_ext

phase_ext [k-1..0]

1211

X0 [m..0] → X0
Y0 [m..0] → Y0   phase_ext
Zi+1 [k-1..0] → Zi+1

(c)

Fig. 13

```
package parameters is
constant number_of_coefficients: integer;
constant m : integer;      -- bit-length of X and Y components
constant k : integer;      -- bit-length of phase
type    array_of_integers is array(14 downto 0) of integer;
constant coefficients              : array_of_integers;
constant coefficients_for_init : bit_vector;
constant bit_length_extension_positive : bit_vector;
constant bit_length_extension_negative : bit_vector;
constant minus_PI : integer;
end parameters;



package body parameters is
constant number_of_coefficients : integer:= 15;
constant m : integer := 16;
constant k : integer := 19;
constant coefficients  : array_of_integers :=
(5,10,20,41,81,163,326,652,1304,2607,5208,10377,20442,38688,65536);
constant coefficients_for_init : bit_vector :=
('0','0','0','0','0','0','0','0','0','0','0','0','0','0','0','0','0','0','0');
constant bit_length_extension_positive  : bit_vector :=
('0','0','0','0','0','0','0','0','0','0','0','0','0','0','0','0','0');
constant bit_length_extension_negative : bit_vector  :=
('1','0','0','0','0','0','0','0','0','0','0','0','0','0','0','0','0');
constant minus_PI : integer := -262144;
end parameters;

library IEEE;
use IEEE.std_logic_1164.all;
use IEEE.std_logic_arith.conv_std_logic_vector;
use IEEE.numeric_std.all;
use IEEE.std_logic_signed.CONV_INTEGER;
use work.parameters.all;


--------------------------------------DECLARATION OF PHASE_COMPUTATION ENTITY-------------------
ENTITY Phase_computation IS
        PORT( SIGNAL clk_ext            :       IN  std_logic                   ;
                SIGNAL clk_algorithm    :       IN  std_logic                   ;

                SIGNAL X                :       IN  bit_vector  (m-1 DOWNTO 0)  ;
                SIGNAL Y                :       IN  bit_vector  (m-1 DOWNTO 0)  ;
                SIGNAL phase            :       OUT bit_vector  (k-1 DOWNTO 0));
END Phase_computation;
--------------------------------------------------------------------------------------------------------------------
```

```
---------------------------------------------------MODULE 1200------------------------------------
library IEEE;
use IEEE.std_logic_1164.all;
use IEEE.std_logic_arith.conv_std_logic_vector;
use IEEE.numeric_std.all;
use IEEE.std_logic_signed.CONV_INTEGER;
use work.parameters.all;


ENTITY Module_1200 IS
        PORT(X, Y                       :       IN   bit_vector  (m-1 DOWNTO 0) ;
                X_ext, Y_ext            :       OUT bit_vector  (m   DOWNTO 0));
END Module_1200;


ARCHITECTURE Arch_Module_1200 OF Module_1200 IS

BEGIN

        process_Module_1200 : process (X, Y) is

        variable X_pos: bit_vector(m DOWNTO 0) := bit_length_extension_positive;
        variable X_neg: bit_vector(m DOWNTO 0) := bit_length_extension_negative;
        variable Y_pos: bit_vector(m DOWNTO 0) := bit_length_extension_positive;
        variable Y_neg: bit_vector(m DOWNTO 0) := bit_length_extension_negative;
        begin

                if   X(m-1)='0' and Y(m-1)='0' then
                        X_pos(m-1 DOWNTO 0):= X;
                        X_ext <= X_pos;
                        Y_pos(m-1 DOWNTO 0):= Y;
                        Y_ext  <= Y_pos;
                elsif X(m-1)='0' and Y(m-1)='1' then
                        X_pos(m-1 DOWNTO 0):= X;
                        X_ext  <= X_pos;
                        Y_neg(m-1 DOWNTO 0):= Y;
                        Y_ext  <= Y_neg;
                elsif X(m-1)='1' and Y(m-1)='0' then
                        X_neg(m-1 DOWNTO 0):= X;
                        X_ext  <= X_neg;
                        Y_pos(m-1 DOWNTO 0):= Y;
                        Y_ext  <= Y_pos;
                else X_neg(m-1 DOWNTO 0):= X;
                        X_ext   <= X_neg;
                        Y_neg(m-1 DOWNTO 0):= Y;
                        Y_ext   <= Y_neg;

                end if;
        end process;


END ARCHITECTURE Arch_Module_1200;
---------------------------------------------------------END MODULE 1200---------------------------------
```

```
-----------------------------------------------------------MODULE 1201------------------------------------
library IEEE;
use IEEE.std_logic_1164.all;
use IEEE.numeric_std.all;
use IEEE.std_logic_signed.CONV_INTEGER;
use IEEE.std_logic_arith.conv_std_logic_vector;
use work.parameters.all;

ENTITY Module_1201 IS
        PORT( clk_ext              :      IN   std_logic                    ;
                clk_algorithm      :      IN  std_logic                     ;
                X_ext              :      IN   bit_vector (m DOWNTO 0) ;
                Y_ext              :      IN   bit_vector (m DOWNTO 0) ;
                Xi_plus_1          :      IN   bit_vector (m DOWNTO 0) ;
                Yi_plus_1          :      IN   bit_vector (m DOWNTO 0) ;
                Zi_plus_1          :      IN   bit_vector (k-1 DOWNTO 0);
                X0                 :      OUT bit_vector (m DOWNTO 0) ;
                Y0                 :      OUT bit_vector (m DOWNTO 0) ;
                Xi                 :      OUT bit_vector (m DOWNTO 0) ;
                Yi                 :      OUT bit_vector (m DOWNTO 0) ;
                Zi                 :      OUT bit_vector (k-1 DOWNTO 0);
                coeff              :      OUT bit_vector (k-1 DOWNTO 0);
                i                  :      OUT integer                   );
END Module_1201;

ARCHITECTURE Arch_Module_1201 OF Module_1201 IS

BEGIN
        process_Module_1201 : process (clk_ext, clk_algorithm, X_ext, Y_ext, Xi_plus_1,
Yi_plus_1, Zi_plus_1) is

                variable j                     :      integer:=0;
                variable l                     :      integer:=0;
                variable reset                 :      integer:=1;
                variable table_of_coefficients :      array_of_integers := coefficients;

                begin
                if rising_edge(clk_ext) then
                        if l=0 then
                        reset:=1;
                        l:=1;
                        end if;
                end if;

                if reset=1 then
                                        j:=0;
                                        reset:=0;

                elsif reset=0 then
                        if rising_edge(clk_algorithm) then
```

```
                    case j is
                    when 0  =>      Xi <= X_ext;
                                                            Yi <= Y_ext;
                            Zi<= coefficients_for_init;
                            coeff <= to_bitvector(
conv_std_logic_vector(table_of_coefficients(0),k) );
                            i<= 0;
                            X0<= X_ext;
                            Y0<= Y_ext;

                    when others =>
                            Xi<= Xi_plus_1;
                            Yi<= Yi_plus_1;
                            Zi<= Zi_plus_1 ;
                            coeff <= to_bitvector(
conv_std_logic_vector(table_of_coefficients(j),k) );
                            i<= j;

                    end case;
                    j := j+1;
                    if j=number_of_coefficients then
                            j := 0;
                    end if;
              end if;

        end if;


        end process;
END Arch_Module_1201;
----------------------------------------------------------END MODULE 1201---------------------------------
```

```
--------------------------------------------------------MODULE 1202 and 1203-----------------------------
library IEEE;
use IEEE.std_logic_1164.all;
use IEEE.numeric_std.all;
use IEEE.std_logic_signed.CONV_INTEGER;
use IEEE.std_logic_arith.conv_std_logic_vector;
use work.parameters.all;


ENTITY Module_1202_and_1203 IS
        PORT( input, XY_component :   IN    bit_vector  (m DOWNTO 0) ;
                data_out              :  OUT bit_vector  (m DOWNTO 0));
END Module_1202_and_1203;


ARCHITECTURE Arch_Module_1202_and_1203 OF Module_1202_and_1203 IS



---------------------------------------------------------function negate data------------------------------------
        function negate_bit_vector_data (bit_vector_data : bit_vector(m downto 0)) return
bit_vector is


        variable data_to_negate  :      bit_vector  (m downto 0);
        variable data_negated    :      bit_vector  (m downto 0);


        begin
data_negated := to_bitvector( conv_std_logic_vector(
(CONV_INTEGER(not to_stdlogicvector(bit_vector_data)) + 1) , (m+1)) );
                return data_negated ;


        end negate_bit_vector_data;
------------------------------------------------------------------------------------------------------------------


BEGIN


        Process_Module_1202_and_1203 : process(input, XY_component) is


        variable product_of_signs : bit;


        begin
                --------------------------sign_test--------------------------
                product_of_signs := input(m)xor XY_component(m);
                ----------------------product data by sign---------------------
                if product_of_signs = '1' then
                        data_out <= negate_bit_vector_data(XY_component);
                else
                        data_out <= XY_component;
                end if;


        end process;


END Arch_Module_1202_and_1203;
------------------------------------------------------END MODULE 1202 and 1203--------------------------
```

```
-----------------------------------------------------------MODULE 1204--------------------------------------
library IEEE;
use IEEE.std_logic_1164.all;
use IEEE.numeric_std.all;
use IEEE.std_logic_signed.CONV_INTEGER;
use IEEE.std_logic_arith.conv_std_logic_vector;
use work.parameters.all;


ENTITY Module_1204 IS
        PORT( Xi, Yi                    : IN    bit_vector  (m DOWNTO 0);
                sign_Xi_by_sign_Yi  :  OUT bit                      );
END Module_1204;

ARCHITECTURE Arch_Module_1204 OF Module_1204 IS

BEGIN
        Process_Module_1204 : process(Xi, Yi) is

        variable product_of_signs: bit  ;

        begin
                --------------------------sign_test--------------------------
                product_of_signs := Xi(m) xor Yi(m);
                -----------------------product of signs-----------------------
                sign_Xi_by_sign_Yi <= product_of_signs;

        end process;

END Arch_Module_1204;
-----------------------------------------------------------END MODULE 1204----------------------------------
```

```
-----------------------------------------------------MODULE 1205 and 1206----------------------------
library IEEE;
use IEEE.std_logic_1164.all;
use IEEE.numeric_std.all;
use IEEE.std_logic_signed.CONV_INTEGER;
use IEEE.std_logic_arith.conv_std_logic_vector;
use work.parameters.all;


ENTITY Module_1205_and_1206 IS
        PORT( length_of_shift   : IN  INTEGER                        ;
                data_in         : IN  BIT_VECTOR  (m DOWNTO 0)   ;
                data_out        : OUT BIT_VECTOR  (m DOWNTO 0));
END Module_1205_and_1206;



ARCHITECTURE Arch_Module_1205_and_1206 OF Module_1205_and_1206 IS

BEGIN

        shifter_function : process( data_in,length_of_shift) is

        variable data_shifted    :         BIT_VECTOR  (m DOWNTO 0);

        begin

                if data_in(m)='1' then
data_shifted := to_bitvector( conv_std_logic_vector( (CONV_INTEGER(not
to_stdlogicvector(data_in)) + 1), (m+1)));
                        data_shifted :=  data_shifted srl length_of_shift ;
                        data_shifted := to_bitvector( conv_std_logic_vector(
(CONV_INTEGER(not
to_stdlogicvector(data_shifted)) + 1), (m+1)));
                else
                        data_shifted := data_in srl length_of_shift ;
                end if;
                data_out <= data_shifted;

        end process;

END ARCHITECTURE Arch_Module_1205_and_1206;
-------------------------------------------------------END MODULE 1205 and 1206--------------------------
```

```
-----------------------------------------------------------MODULE 1207-------------------------------------
library IEEE;
use IEEE.std_logic_1164.all;
use IEEE.numeric_std.all;
use IEEE.std_logic_signed.CONV_INTEGER;
use IEEE.std_logic_arith.conv_std_logic_vector;
use work.parameters.all;


ENTITY Module_1207 IS
        PORT( sign              :  IN    bit                          ;
              coeff             :  IN    bit_vector (k-1 DOWNTO 0);
              sign_by_coeff     :  OUT  bit_vector (k-1 DOWNTO 0));
END Module_1207;


ARCHITECTURE Arch_Module_1207 OF Module_1207 IS

-----------------------------------------------------function negate data-------------------------------------
        function negate_bit_vector_data ( bit_vector_data : bit_vector(k-1 downto 0))
return bit_vector is

                variable data_to_negate :       bit_vector(k-1 downto 0);
                variable data_negated   :       bit_vector(k-1 downto 0);

        begin

                data_negated := to_bitvector( conv_std_logic_vector( (CONV_INTEGER(not
to_stdlogicvector(bit_vector_data)) + 1), k) );
                return data_negated ;

        end negate_bit_vector_data;
------------------------------------------------------------------------------------------------------------------


BEGIN

        Process_Module_1207 : process(sign, coeff) is

        begin
                -----------------------product data by sign---------------------
                if sign='1' THEN
                        sign_by_coeff <= negate_bit_vector_data(coeff);
                else
                        sign_by_coeff <= coeff;
                end if;

        end process;

END Arch_Module_1207;
----------------------------------------------------------END MODULE 1207----------------------------------
```

```
------------------------------------------------------------MODULE 1208-------------------------------------
library IEEE;
use IEEE.std_logic_1164.all;
use IEEE.numeric_std.all;
use IEEE.std_logic_signed.CONV_INTEGER;
use IEEE.std_logic_arith.conv_std_logic_vector;
use work.parameters.all;


ENTITY Module_1208 IS
        PORT( input, Xi   :  IN    BIT_VECTOR  (m DOWNTO 0) ;
                Xi_plus_1 :  OUT BIT_VECTOR  (m DOWNTO 0));
END Module_1208;


ARCHITECTURE Arch_Module_1208 OF Module_1208 IS

BEGIN

        Process_Module_1208 : process(input, Xi) is

        variable INTEGER_input, INTEGER_Xi     :       integer                            ;
        variable data                          :       BIT_VECTOR  (m DOWNTO 0);

        begin

                INTEGER_input := CONV_INTEGER ( to_stdlogicvector (input) ) ;
                INTEGER_Xi        := CONV_INTEGER ( to_stdlogicvector (Xi) ) ;
                data  := to_bitvector( conv_std_logic_vector( (INTEGER_Xi +
INTEGER_input), (m+1)) );
                Xi_plus_1 <= data;

        end process;

END Arch_Module_1208;
-------------------------------------------------------------END MODULE 1208----------------------------------
```

```
-------------------------------------------------------------MODULE 1209-------------------------------------
library IEEE;
use IEEE.std_logic_1164.all;
use IEEE.numeric_std.all;
use IEEE.std_logic_signed.CONV_INTEGER;
use IEEE.std_logic_arith.conv_std_logic_vector;
use work.parameters.all;


ENTITY Module_1209 IS
        PORT( input, Yi   : IN    BIT_VECTOR  (m DOWNTO 0) ;
                 Yi_plus_1 :  OUT BIT_VECTOR  (m DOWNTO 0));
END Module_1209;



ARCHITECTURE Arch_Module_1209 OF Module_1209 IS

        BEGIN

        Process_Module_1209 : process(input, Yi) is

        variable INTEGER_input, INTEGER_Yi  :   integer                        ;
        variable data                               :  BIT_VECTOR (m DOWNTO 0);

        begin

                 INTEGER_input := CONV_INTEGER ( to_stdlogicvector (input) ) ;
                 INTEGER_Yi       := CONV_INTEGER ( to_stdlogicvector (Yi) ) ;
                 data  := to_bitvector ( conv_std_logic_vector( (INTEGER_Yi -
INTEGER_input), (m+1)) );
                 Yi_plus_1 <= data;

        end process;

END Arch_Module_1209;
------------------------------------------------------------END MODULE 1209---------------------------------
```

-----------------------------------------------------------------MODULE 1210------------------------------------------

library IEEE;
use IEEE.std_logic_1164.all;
use IEEE.numeric_std.all;
use IEEE.std_logic_signed.CONV_INTEGER;
use IEEE.std_logic_arith.conv_std_logic_vector;
use work.parameters.all;


ENTITY Module_1210 IS
        PORT(     Zi        : IN  BIT_VECTOR  (k-1 DOWNTO 0)   ;
                  input     : IN  BIT_VECTOR  (k-1 DOWNTO 0)   ;
                  Zi_plus_1  : OUT BIT_VECTOR  (k-1 DOWNTO 0));
END Module_1210;


ARCHITECTURE Arch_Module_1210 OF Module_1210 IS

BEGIN

        Process_Module_1210 : process(Zi, input) is

        variable INTEGER_Zi           :       integer:=0                       ;
        variable INTEGER_input        :       integer                          ;
        variable data                 :       BIT_VECTOR  (k-1 DOWNTO 0);

        begin

                INTEGER_Zi      := CONV_INTEGER ( to_stdlogicvector (Zi) ) ;
                INTEGER_input := CONV_INTEGER ( to_stdlogicvector (input) ) ;

                data := to_bitvector( conv_std_logic_vector( (INTEGER_Zi + INTEGER_input),
k) );
                Zi_plus_1 <= data;

        end process;

END Arch_Module_1210;
------------------------------------------------------------END MODULE 1210----------------------------------

```
-------------------------------------------------------------MODULE 1211-------------------------------------
library IEEE;
use IEEE.std_logic_1164.all;
use IEEE.numeric_std.all;
use IEEE.std_logic_signed.CONV_INTEGER;
use IEEE.std_logic_arith.conv_std_logic_vector;
use work.parameters.all;


ENTITY Module_1211 IS
        PORT( X0, Y0         : IN    bit_vector (m DOWNTO 0)  ;
                   Zi_plus_1  : IN    bit_vector (k-1 DOWNTO 0) ;
                   phase_ext :  OUT bit_vector (k-1 DOWNTO 0));
END Module_1211;



ARCHITECTURE Arch_Module_1211 OF Module_1211 IS

BEGIN

        Process_Module_1211 : process(X0, Y0, Zi_plus_1) is

        variable sign_of_product          :        bit   ;
        variable phase_in_new_domain :          integer;

        begin
        ----------------------------case X positiv----------------------------
                if X0(m) = '0' then
                        phase_in_new_domain := CONV_INTEGER(
to_stdlogicvector(Zi_plus_1) ) ;
                else
                        case     Y0(m) is
when '0'         => phase_in_new_domain := CONV_INTEGER( to_stdlogicvector(Zi_plus_1) )
- (minus_PI);
when others => phase_in_new_domain := CONV_INTEGER(
to_stdlogicvector(Zi_plus_1) ) + (minus_PI);
                               end case;
                        end if;
                        phase_ext <= to_bitvector (
conv_std_logic_vector(phase_in_new_domain,k) );


        end process;

END Arch_Module_1211;
-------------------------------------------------------------END MODULE 1211--------------------------------
```

```
---------------------------------------------------------MODULE 1212-------------------------------------
library IEEE;
use IEEE.std_logic_1164.all;
use IEEE.numeric_std.all;
use IEEE.std_logic_signed.CONV_INTEGER;
use IEEE.std_logic_arith.conv_std_logic_vector;
use work.parameters.all;


ENTITY Module_1212 IS
        PORT( clk_algorithm     : IN    std_logic  ;
                  i             : IN INTEGER;
                  phase_ext     : IN     bit_vector  (k-1 downto 0) ;
                  phase         : OUT bit_vector  (k-1 downto 0));
END Module_1212;



ARCHITECTURE Arch_Module_1212 of Module_1212 is

BEGIN

        Process_Module_1212 : process(clk_algorithm, i) is

        begin

                if rising_edge(clk_algorithm) then
                        if      i=number_of_coefficients-1 then
                                phase <= phase_ext;
                        end if;
                end if;

        end process;

END Arch_Module_1212;
-----------------------------------------------------------END MODULE 1212----------------------------------
```

-----------------------------------ARCHITECTURE OF PHASE_COMPUTATION ENTITY---------------

ARCHITECTURE Architecture_of_Phase_computation OF Phase_computation IS

-----------------------------------------------DECLARATION OF THE INTERCONNECTIONS------------

```
        SIGNAL i                          :        integer                        ;
        SIGNAL phase_ext                  :        bit_vector (k-1 DOWNTO 0);

        SIGNAL coeff                      :        bit_vector (k-1 DOWNTO 0);
        SIGNAL coeff_by_sign              :        bit_vector (k-1 DOWNTO 0);
        SIGNAL sign                       :        bit                            ;
        SIGNAL X_ext                      :        bit_vector (m  DOWNTO 0);
        SIGNAL Y_ext                      :        bit_vector (m  DOWNTO 0);
                    SIGNAL X0                       :        bit_vector  (m
DOWNTO 0);
        SIGNAL Y0                         :        bit_vector (m  DOWNTO 0);
        SIGNAL Xi                         :        bit_vector (m  DOWNTO 0);
        SIGNAL Yi                         :        bit_vector (m  DOWNTO 0);
        SIGNAL Zi                         :        bit_vector (k-1 DOWNTO 0);
        SIGNAL Xi_plus_1                  :        bit_vector (m  DOWNTO 0);
        SIGNAL Yi_plus_1                  :        bit_vector (m  DOWNTO 0);
        SIGNAL Zi_plus_1                  :        bit_vector (k-1 DOWNTO 0);
        SIGNAL X_by_sign                  :        bit_vector (m  DOWNTO 0);
        SIGNAL Y_by_sign                  :        bit_vector (m  DOWNTO 0);
        SIGNAL X_by_sign_shifted          :        bit_vector (m  DOWNTO 0);
        SIGNAL Y_by_sign_shifted          :        bit_vector (m  DOWNTO 0);
```

--------------------------------------------DECLARATION OF THE COMPONENTS----------------------

```
COMPONENT Module_1200
        PORT( X, Y                        :        IN   bit_vector (m-1 DOWNTO 0);
                X_ext, Y_ext              :        OUT bit_vector (m  DOWNTO 0));
END COMPONENT;


COMPONENT Module_1201 IS
    PORT(       clk_ext                   :        IN   std_logic                 ;
                clk_algorithm             :        IN   std_logic                 ;

                X_ext                     :        IN   bit_vector (m  DOWNTO 0);
                Y_ext                     :        IN   bit_vector (m  DOWNTO 0);
                Xi_plus_1                 :        IN   bit_vector (m  DOWNTO 0);
                Yi_plus_1                 :        IN   bit_vector (m  DOWNTO 0);

                Zi_plus_1                 :        IN   bit_vector (k-1 DOWNTO 0);
                X0                        :        OUT bit_vector (m  DOWNTO 0);
                Y0                        :        OUT bit_vector (m  DOWNTO 0);
                Xi                        :        OUT bit_vector (m  DOWNTO 0);
```

```
            Yi                              :        OUT bit_vector (m   DOWNTO 0);
            Zi                              :        OUT bit_vector (k-1 DOWNTO 0);


            coeff                           :        OUT bit_vector (k-1 DOWNTO 0);


            i                               :        OUT INTEGER                    );
END COMPONENT;



COMPONENT Module_1202_and_1203
      PORT( input, XY_component            :        IN   bit_vector (m DOWNTO 0) ;
            data_out                       :        OUT bit_vector (m DOWNTO 0));
END COMPONENT;



COMPONENT Module_1204 IS
      PORT( Xi, Yi                         :        IN   bit_vector (m DOWNTO 0) ;
            sign_Xi_by_sign_Yi             :        OUT bit                        );
END COMPONENT;



COMPONENT Module_1205_and_1206 IS
      PORT( length_of_shift                :        IN    INTEGER                    ;
            data_in                        :        IN    BIT_VECTOR (m DOWNTO 0) ;
            data_out                       :        OUT BIT_VECTOR (m DOWNTO 0));
END COMPONENT;



COMPONENT Module_1207 IS
      PORT( sign                           :        IN    bit                        ;
            coeff                          :        IN    bit_vector (k-1 DOWNTO 0) ;
            sign_by_coeff                  :        OUT bit_vector (k-1 DOWNTO 0));
END COMPONENT;



COMPONENT Module_1208 IS
      PORT( input, Xi                      :        IN    BIT_VECTOR (m DOWNTO 0) ;
            Xi_plus_1                      :        OUT BIT_VECTOR (m DOWNTO 0));
END COMPONENT;



COMPONENT Module_1209 IS
      PORT( input, Yi               :       IN   BIT_VECTOR (m DOWNTO 0) ;
            Yi_plus_1                      :        OUT BIT_VECTOR (m DOWNTO 0));
END COMPONENT;



COMPONENT Module_1210 IS
      PORT( Zi                             :        IN    BIT_VECTOR (k-1 DOWNTO 0) ;
            input                          :        IN    BIT_VECTOR (k-1 DOWNTO 0) ;
```

```
                Zi_plus_1                    :          OUT BIT_VECTOR (k-1 DOWNTO 0));
END COMPONENT;



COMPONENT Module_1211 IS
        PORT( X0, Y0                         :          IN    bit_vector (m   DOWNTO 0) ;
              Zi_plus_1                      :          IN    bit_vector (k-1 DOWNTO 0) ;

              phase_ext                      :          OUT bit_vector (k-1 DOWNTO 0));
END COMPONENT;



COMPONENT Module_1212 IS
        PORT( clk_algorithm                  :          IN    std_logic               ;
              i                              :          IN       INTEGER               ;
              phase_ext                      :          IN    bit_vector (k-1 downto 0)  ;
              phase                          :          OUT bit_vector (k-1 downto 0));
END COMPONENT;




-------------------------------------------------MAPPING OF THE COMPONENTS------------------------



BEGIN

component_0  : Module_1200              port map (X, Y, X_ext, Y_ext);
component_1  : Module_1201              port map (clk_ext, clk_algorithm, X_ext,
Y_ext, Xi_plus_1, Yi_plus_1,

                                                         Zi_plus_1, X0, Y0,

Xi, Yi, Zi, coeff,i);
component_2  : Module_1202_and_1203     port map (Xi,Yi,Y_by_sign);
component_3  : Module_1202_and_1203     port map (Yi,Xi,X_by_sign);
component_4  : Module_1204              port map (Xi,Yi,sign);
component_5  : Module_1205_and_1206     port map (i, Y_by_sign,Y_by_sign_shifted);
component_6  : Module_1205_and_1206     port map (i, X_by_sign,X_by_sign_shifted);
component_7  : Module_1207              port map (sign, coeff, coeff_by_sign);
component_8  : Module_1208              port map (Y_by_sign_shifted, Xi, Xi_plus_1);
component_9  : Module_1209              port map (X_by_sign_shifted, Yi, Yi_plus_1);
component_10 : Module_1210              port map (Zi, coeff_by_sign, Zi_plus_1);
component_11 : Module_1211              port map (X0, Y0, Zi_plus_1, phase_ext);
component_12 : Module_1212              port map (clk_algorithm, i, phase_ext,
phase);

END Architecture_of_Phase_computation;
```

Fig. 14

Fig. 14A

Fig. 14B

Fig. 15

General and equivalent formulas for the computation of the coefficients for a phase coded on k bits

$$coeff_i = atan_{deg}(2^{-i}) \cdot \frac{2^{k-1}}{180} \qquad \textbf{1500}$$

$$coeff_i = atan_{rad}(2^{-i}) \cdot \frac{2^{k-1}}{\pi} \qquad \textbf{1501}$$

Formula to compute the - $\pi$ equivalent of a phase coded on $k$ bits.
– $\pi_k$ is the signed integer number corresponding to – $\pi$

$$-\pi_k = -2^{k-1} \qquad \textbf{1502}$$

Formulas for the computation of the X and Y components of bit-length $m$ in function of a given phase for the simulation of the algorithm.

$$X = (2^{m-1} - 1) \cdot \cos(angle) \qquad \textbf{1503}$$

$$Y = (2^{m-1} - 1) \cdot \sin(angle) \qquad \textbf{1504}$$

Formulas to calibrate the computed phase in degrees or radians

$$phase_{calib,\ deg} = \frac{180}{2^{k-1}} \cdot phase \qquad \textbf{1505}$$

$$phase_{calib,\ rad} = \frac{\pi}{2^{k-1}} \cdot phase \qquad \textbf{1506}$$

Relation that must be mandatory satisfied between the frequency of the external clock clk_ext and the frequency of the algorithm clock clk_algorithm for the synchronization of the phase computation with an external clock.

$$f_{clk\_ext} = \frac{number\ of\ cycles\ of\ clk\_ext}{number\ of\ coefficients} \cdot f_{clk\_algorithm} \qquad \textbf{1507}$$

**Europäisches Patentamt**
**European Patent Office**
**Office européen des brevets**

# EUROPEAN SEARCH REPORT

Application Number

EP 15 17 8389

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | Jean-Jacques Vandenbussche ET AL: "Development of a Low-Cost Accurate Phase Measurement System", Conference Paper, 7 March 2014 (2014-03-07), XP055248197, Retrieved from the Internet: URL:https://www.researchgate.net/publication/260589965_Development_of_a_Low-Cost_Accurate_Phase_Measurement_System [retrieved on 2016-02-08] * section B * | 1-9 | INV.<br>G06F7/544<br>G01Q10/06<br>B82Y35/00 |
| X | Paul Köchert ET AL: "A Fast Phasemeter for Interferometric Applications with an Accuracy in the Picometer Regime", 10th IMEKO TC14 Symposium on Laser Metrology for Precision Measurement and Inspection in Industry, 1 September 2011 (2011-09-01), XP055248198, Retrieved from the Internet: URL:http://www.imeko.org/publications/tc14-2011/IMEKO-TC14-2011-34.pdf [retrieved on 2016-02-08] * section 2 * | 1-9 | |

TECHNICAL FIELDS SEARCHED (IPC)

G06F
G01Q
B82Y

-/--

The present search report has been drawn up for all claims

| Place of search | Date of completion of the search | Examiner |
|---|---|---|
| Munich | 8 February 2016 | Prins, Leendert |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 15 17 8389

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | T Kranthi Kiran ET AL: "High speed all digital phase locked loop (DPLL) using pipelined carrier synthesis techniques", International Journal of Advanced Research in Electronics and Communication Engineering, 1 January 2013 (2013-01-01), pages 2278-909, XP055248245, Retrieved from the Internet: URL:http://ijarece.org/wp-content/uploads/2013/08/IJARECE-VOL-2-ISSUE-1-11-16.pdf [retrieved on 2016-02-08] * figure 3 * | 1-9 | |
| A | US 2010/031404 A1 (RYCHEN JOERG [CH]) 4 February 2010 (2010-02-04) * figure 2 * | 1-9 | |
| A,D | JACK E VOLDER: "The CORDIC Trigonometric Computing Technique", IEEE TRANSACTIONS ON ELECTRONIC COMPUTERS, IEEE, U, vol. EC-12, no. 3, 1 September 1959 (1959-09-01), pages 330-334, XP011275619, ISSN: 0367-7508 * the whole document * | 1-9 | TECHNICAL FIELDS SEARCHED (IPC) |

-/--

The present search report has been drawn up for all claims

| Place of search | Date of completion of the search | Examiner |
|---|---|---|
| Munich | 8 February 2016 | Prins, Leendert |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

**Application Number**

EP 15 17 8389

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | ANDRAKA R ED - ASSOCIATION FOR COMPUTING MACHINERY: "SURVEY OF CORDIC ALGORITHMS FOR FPGA BASED COMPUTERS", ACM/SIGDA INTERNATIONAL SYMPOSIUM ON FIELD PROGRAMMABLE GATE ARRAYS. FPGA '98. MONTEREY, CA, FEB. 22 - 24, 1998; [ACM/SIGDA INTERNATIONAL SYMPOSIUM ON FIELD PROGRAMMABLE GATE ARRAYS], NEW YORK, NY : ACM, US, vol. 6TH CONF, 22 February 1998 (1998-02-22), pages 191-200, XP000883995, DOI: 10.1145/275107.275139 ISBN: 978-0-89791-978-4 * the whole document * | 1-9 | |
| A | MEHER P K ET AL: "50 Years of CORDIC: Algorithms, Architectures, and Applications", IEEE TRANSACTIONS ON CIRCUITS AND SYSTEMS I: REGULAR PAPERS, IEEE, US, vol. 56, no. 9, 1 September 2009 (2009-09-01), pages 1893-1907, XP011333527, ISSN: 1549-8328, DOI: 10.1109/TCSI.2009.2025803 * the whole document * | 1-9 | **TECHNICAL FIELDS SEARCHED (IPC)** |

The present search report has been drawn up for all claims

| Place of search | Date of completion of the search | Examiner |
|---|---|---|
| Munich | 8 February 2016 | Prins, Leendert |

EPO FORM 1503 03.82 (P04C01)

## ANNEX TO THE EUROPEAN SEARCH REPORT
## ON EUROPEAN PATENT APPLICATION NO.

EP 15 17 8389

This annex lists the patent family members relating to the patent documents cited in the above-mentioned European search report.
The members are as contained in the European Patent Office EDP file on
The European Patent Office is in no way liable for these particulars which are merely given for the purpose of information.

08-02-2016

| Patent document cited in search report | Publication date | Patent family member(s) | Publication date |
|---|---|---|---|
| US 2010031404 A1 | 04-02-2010 | EP 2092292 A1<br>JP 5059871 B2<br>JP 2010512518 A<br>US 2010031404 A1<br>WO 2008071013 A1 | 26-08-2009<br>31-10-2012<br>22-04-2010<br>04-02-2010<br>19-06-2008 |

EPO FORM P0459

For more details about this annex : see Official Journal of the European Patent Office, No. 12/82

## REFERENCES CITED IN THE DESCRIPTION

**Non-patent literature cited in the description**

- **JACK E. VOIDER.** The CORDIC Computing Technique. *IRE Transactions on Electronic Computers,* September 1959, 330-334

- **RAY ANDRAKA.** *A survey of CORDIC algorihms for FPGA based computers*